# FASCICULE DE BREVET EUROPEEN

(11) **EP 2 269 109 B1**
(45) Date de publication et mention de la délivrance du brevet: **28.12.2011**
(21) Numéro de dépôt: 09735541.6
(22) Date de dépôt: 17.04.2009
(51) Int. Cl.: G02B 26/08, G02B 3/14, G02B 5/08, G02C 7/08, G02B 1/06, B81B 3/00

(54) **MEMBRANE PERFECTIONNEE NOTAMMENT POUR DISPOSITIF OPTIQUE A MEMBRANE DEFORMABLE**
VERBESSERTE MEMBRAN, SPEZIELL FÜR EINE OPTISCHE VORRICHTUNG MIT EINER VERFORMBAREN MEMBRAN
IMPROVED MEMBRANE, ESPECIALLY FOR AN OPTICAL DEVICE HAVING A DEFORMABLE MEMBRANE

(30) Priorité: 21.04.2008 FR 0852668
(43) Date de publication de la demande: 05.01.2011
(73) Titulaire: Commissariat à l'Énergie Atomique et aux Énergies Alternatives, 75015 Paris (FR)
(72) Inventeur: BOLIS, Sébastien, F-38920 Crolles (FR); BARBE, Jean-Charles, F-38160 Izeron (FR); CHARVET, Pierre-Louis, F-38950 Saint Martin Le Vinoux (FR)
(74) Mandataire: Ilgart, Jean-Christophe
(86) Numéro de dépôt international: PCT/EP2009/054621
(87) Numéro de publication internationale: WO 2009/130171

(56) Documents cités:
- WO-A-2004/019362
- JP-A- 2002 357 774
- JP-A- 2003 170 582
- JP-A- 2004 205 975
- JP-A- 2008 058 841
- US-A1- 2005 041 301
- IL WOONG JUNG ET AL: "Single-Crystal-Silicon Continuous Membrane Deformable Mirror Array for Adaptive Optics in Space-Based Telescopes" IEEE JOURNAL OF SELECTED TOPICS IN QUANTUM ELECTRONICS, IEEE SERVICE CENTER, PISCATAWAY, NJ, US, vol. 13, no. 2, 1 mars 2007 (2007-03-01), pages 162-167, XP011179419 ISSN: 1077-260X
- QUEVY E ET AL: "Realization and actuation of continuous-membrane by an array of 3D self-assembling micro-mirrors for adaptive optics" PROCEEDINGS OF THE IEEE 14TH. ANNUAL INTERNATIONAL CONFERENCE ON MICRO ELECTRO MECHANICAL SYSTEMS. MEMS 2001. INTERLAKEN, SWITZERLAND, JAN. 21 - 25, 2001; [IEEE INTERNATIONAL MICRO ELECTRO MECHANICAL SYSTEMS CONFERENCE], NEW YORK, NY : IEEE, US, vol. CONF. 14, 21 janvier 2001 (2001-01-21), pages 329-332, XP010534617 ISBN: 978-0-7803-5998-7

## Description

### DOMAINE TECHNIQUE

La présente invention est relative à un dispositif optique à membrane déformable tel une lentille liquide à focale variable, une lentille liquide à correction d'aberrations optique en optique adaptative ou même un miroir à membrane déformable.

Parmi tous les types de lentilles liquides à distance focale variable, il en existe un formé d'un liquide optique travaillant à volume constant entre des parois parmi lesquelles au moins une peut être déplacée. Par liquide optique, on entend un liquide qui a des propriétés optiques appropriées à la réfraction de la lumière et qui possède un indice supérieur à 1, typiquement 1,4 ou 1,5. Par la suite on emploiera simplement le terme liquide. Toutefois les lentilles de ce type sont peu utilisées dans les appareils photos miniatures tels que ceux intégrés dans les téléphones-appareils photos car les structures mécaniques de variation de leur distance focale sont complexes, elles pénalisent l'encombrement, le coût et la fiabilité de ces lentilles.

Ces appareils photos miniatures, fonctionnant dans le visible, sont connus sous la dénomination anglo-saxonne CCM pour « compact camera module ». Ces derniers sont plutôt dotés de lentilles constituées d'un ou deux liquides sur lesquels est appliquée une tension afin de modifier leur mouillabilité.

Toutefois, de nombreux développements sont en cours dont notamment la fonction d'autofocus et la fonction zoom. On cherche lors de l'introduction de ces fonctions, à obtenir un temps de réponse le plus court possible. Plus globalement, on cherche à intégrer le plus possible les constituants de ces appareils photos miniatures pour réduire les coûts, l'encombrement et la consommation d'énergie.

Une autre application concerne les caméras fonctionnant dans l'infrarouge (IR). L'avancement en termes d'intégration est moindre, dans la plupart des cas, les optiques sont dissociées des caméras. Plusieurs développements sont en cours dont notamment l'intégration des optiques (création d'un module caméra), l'intégration de la fonction autofocus, ... Pour l'instant, les solutions techniques associées ne sont pas connues et demandent à être définies.

Dans une application de miroir à membrane déformable, cette dernière est réfléchissante. On peut être amené à vouloir ajuster la distance focale du miroir et donc son rayon de courbure. Un tel miroir peut être utilisé en ophtalmologie ou en optique adaptative.

### ÉTAT DE LA TECHNIQUE ANTÉRIEURE

Les dispositifs optiques à distance focale variable tels des lentilles liquides à distance focale variable constituées d'un liquide travaillant à volume constant entre deux parois dont au moins une est mobile ont fait l'objet de plusieurs brevets, par exemple : US-B-5 917 657, US-B-6 344 930, JP-A-10-144975, JP-A-08-114 703, US-A-5 138 494, WO 2003/102636, JP2002-243918 et JP-A-60 220301.

Aucun de ces brevets ne mentionne une application pour un appareil photo de téléphone portable, mais plutôt pour des lunettes, des microscopes optiques et des appareils photos numériques par exemple. En fait les structures mécaniques associées aux membranes sont toutes très complexes et ont un coût beaucoup trop élevé pour ce genre d'application.

Les figures 15A, 15B montrent deux exemples de lentilles liquides à distance focale variable, décrits dans le brevet US-B-5 917 657. Ces lentilles sont choisies car elles illustrent les lentilles les moins complexes.

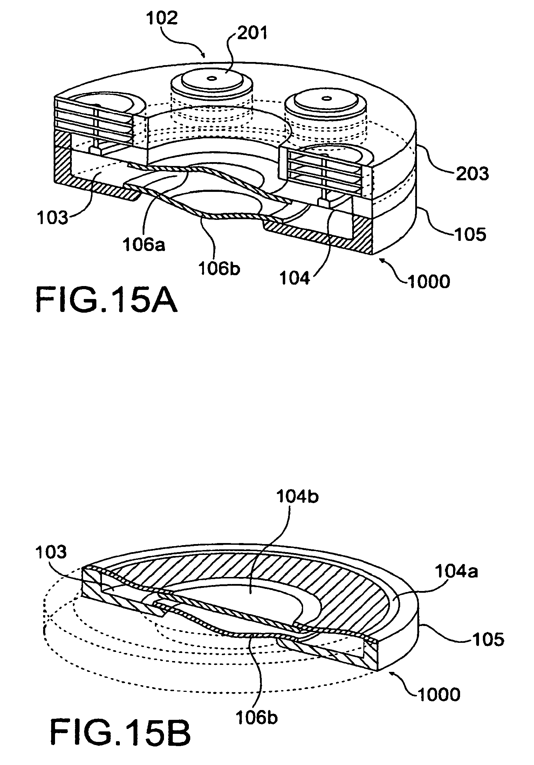

La lentille liquide 1000 de la figure 15A est constituée d'un premier film élastique transparent 106a central, d'un second film élastique transparent central 106b, d'un film élastique 104 périphérique et d'un conteneur périphérique 105. Les premier et second films élastiques transparents 106a, 106b sont placés en vis-à-vis. Le film élastique 104 périphérique est fixé autour du premier film élastique transparent 106a et l'ensemble forme une première membrane déformable. La première membrane est ancrée sur une face du conteneur périphérique 105. La seconde membrane est constituée par le second film élastique. Elle est ancrée sur une autre face du conteneur périphérique. Tous ces éléments sont scellés hermétiquement les uns aux autres et contiennent un liquide 103. Les moyens d'actionnement électrostatiques de la lentille 102, dont la fonction est d'exercer une pression sur le liquide 103, agissent au niveau du film élastique périphérique 104. Ils sont formés de plusieurs actionneurs 201 disposés dans un conteneur 203 en forme de couronne. Ce conteneur est relativement épais. Leur action a lieu sur la membrane via un anneau rapporté sur le film élastique périphérique 104. Les deux conteneurs 105, 203 sont assemblés face à face. Les films élastiques transparents n'ont qu'un rôle optique et le film élastique périphérique n'a qu'un rôle mécanique.

Ces lentilles liquides 1000 présentent des inconvénients que l'on va lister.

Un inconvénient important est lié au type d'actionnement qui est encombrant et complexe notamment à cause du conteneur.

Les procédés de fabrication de ces lentilles sont unitaires et pluridisciplinaires. Ces procédés incluent des techniques issues de la plasturgie pour élaborer et mettre en forme les films, des techniques d'injection et d'usinage pour réaliser les conteneurs. Les procédés d'assemblage hermétique des films au conteneur sont différents selon la nature du scellement (plastique-plastique, plastique-verre, plastique-métal). De plus les scellements à réaliser ne sont pas tous situés dans un même plan, ce qui entraîne des manipulations délicates de films ou de plaques, ce qui complique considérablement le procédé employé et l'outillage nécessaire. Ces techniques ne sont pas compatibles avec les procédés classiques de fabrication par lots employés pour la réalisation de systèmes micro électromécaniques MEMS ou de systèmes micro optoélectromécaniques MOEMS. Leur coût reste en conséquence élevé et leur encombrement également.

De plus, il est difficile de positionner lors de l'assemblage le film élastique transparent au film élastique périphérique et de parfaitement positionner l'anneau lors de son report sur le film 20 élastique périphérique. Une autre difficulté est de parfaitement positionner les actionneurs par rapport à l'anneau. Si le positionnement n'est pas parfait, il en résulte des aberrations optiques qui dégradent la qualité de l'image obtenue.

En outre, il est nécessaire que le film élastique périphérique qui va être déplacé par les moyens d'actionnement électrostatiques aussi bien au repos qu'en fonctionnement soit le plus parallèle possible par rapport à la surface du conteneur périphérique au niveau de l'ancrage. Sinon des aberrations optiques se produisent et elles dégradent la qualité de l'image obtenue. En effet sur la figure 15B, on a représenté en coupe la lentille liquide décrite dans le brevet US-B-5 917 657 à l'exception des moyens d'actionnement électrostatiques. Pour éviter tout risque d'aberration optique, les plans principaux dans lesquels s'étendent les portions de membrane au niveau du scellement au conteneur et du scellement entre les différents films constituant la membrane doivent être sensiblement parallèles. Il est très difficile d'arriver à ces résultats avec les multiples scellements préconisés.

En outre, puisque plusieurs films sont scellés hermétiquement ensemble, à la manière d'un patchwork, et au conteneur pour encapsuler le liquide 4, le risque de fuite n'est pas négligeable. Le document JP-A-2004 205975 divulgue un élément optique électro-mécanique comprenant une jambe ayant un pied et une extrémité libre.

### EXPOSÉ DE L'INVENTION

La présente invention a justement pour but de fournir un dispositif optique à membrane déformable tel qu'une lentille liquide ou un miroir qui ne possède pas les inconvénients mentionnés ci-dessus à savoir la complexité des moyens d'actionnement et leur encombrement, les aberrations optiques, le risque de fuite important, l'incompatibilité avec l'environnement micro-électronique, l'impossibilité d'une fabrication collective selon les standards utilisés en microélectronique.

Pour y parvenir, la présente invention propose un dispositif optique comportant une membrane déformable de manière réversible comportant un film souple possédant au moins une zone d'ancrage périphérique, une zone centrale, une zone intermédiaire entre la zone centrale et la zone d'ancrage périphérique. La membrane est ancrée au niveau de sa zone d'ancrage sur un support. Il comporte de plus des moyens d'actionnement électrostatiques avec une ou plusieurs électrodes fixes portées par le support et une ou plusieurs parties mobiles. Le support et la membrane contribuent à emprisonner un volume constant de liquide en contact avec l'une des faces du film. Les parties mobiles des moyens d'actionnement électrostatiques sont formées chacune d'une jambe se terminant d'un côté par un pied solidaire mécaniquement d'une région de solidarisation du film, cette région de solidarisation étant située dans la zone intermédiaire et de l'autre par une extrémité libre. La jambe intègre une électrode mobile au moins du côté de son extrémité libre. L'actionnement des moyens d'actionnement électrostatiques d'une position de repos à une position de travail a pour effet d'attirer l'électrode mobile vers l'électrode fixe qui est placée en regard et de déplacer le liquide se trouvant au niveau de la région de solidarisation vers la zone centrale de manière à ajuster le rayon de courbure de la membrane.

L'extrémité libre de la jambe peut se trouver soit à l'opposé de la zone centrale par rapport au pied, soit du côté de la zone centrale, à l'opposé de la zone d'ancrage périphérique par rapport au pied.

Pour éviter les fuites, le film comporte au moins une couche continue qui s'étend sur toute sa surface.

Il est possible que le pied soit fixé au film ou fasse partie intégrante du film.

Pour accroître l'efficacité des moyens d'actionnement électrostatiques tout en limitant l'encombrement de la membrane, il est possible que la jambe soit ramifiée du côté de son extrémité libre.

Il est même possible que le pied possède des ramifications, une jambe partant de chaque ramification.

De manière à commander certaines parties mobiles, au moins, des moyens d'actionnement électrostatiques, il est possible qu'un pied coopère avec plusieurs jambes.

Il est même possible de prévoir que les parties mobiles partagent un unique pied.

La jambe peut être confondue avec l'électrode mobile ou au contraire l'électrode mobile peut être un des constituants de la jambe.

La membrane peut comporter en outre une piste conductrice reliée à l'électrode mobile qui court sur le film.

Afin de rendre l'effort mécanique provoqué, lors de l'actionnement des moyens d'actionnement électrostatiques le plus symétrique possible, il est possible que la piste conductrice se divise sur le film en deux brins sensiblement symétriques par rapport à la jambe.

Afin d'améliorer l'efficacité de l'actionnement, le film peut comporter au niveau de la zone intermédiaire une région renforcée au niveau de laquelle le pied est solidarisé au film.

Dans le même but, il possible que le film comporte une zone à souplesse accrue entre la zone d'ancrage et la zone intermédiaire.

Encore dans le même but, il est possible que le film comporte une zone de renfort entre la zone centrale et la zone intermédiaire.

Pour gagner en compacité sans perdre en efficacité, il possible que la jambe comporte plusieurs tronçons raboutés, s'étendant dans des directions différentes.

On peut prévoir un dispositif mécanique pour fixer le pied au film.

L'extrémité libre de la jambe peut dépasser du bord du film.

Le film peut être réalisé à base de matériaux organiques choisis parmi le polydiméthylsiloxane (PDMS), le polyméthacrylate de méthyle (PMMA) le polyéthylène téréphtalate (PET), le polycarbonate (PC), le parylène, les résines époxydes, de matériaux minéraux choisis parmi le dioxyde de silicium, le nitrure de silicium, le germanium, de matériaux métalliques choisis parmi le titane, le nitrure de titane, l'aluminium, l'oxyde d'étain et d'indium (ITO). Plus généralement, les matériaux constitutifs du film doivent lui conférer les propriétés mécaniques décrites ultérieurement ainsi que les propriétés optiques adaptées à l'application c'est-à-dire une application en transmission ou en réflexion.

De la même manière, la partie mobile des moyens d'actionnement électrostatiques peut être réalisée à base de matériaux organiques choisis parmi le polydiméthylsiloxane (PDMS), le polyméthacrylate de méthyle (PMMA) le polyéthylène téréphtalate (PET), le polycarbonate (PC), le parylène, les résines époxydes, de matériaux minéraux choisis parmi le dioxyde de silicium, le nitrure de silicium, le germanium, de matériaux métalliques choisis parmi le titane, le nitrure de titane, l'aluminium, l'oxyde d'étain et d'indium (ITO), l'or, le chrome. Plus généralement, les matériaux constitutifs de la partie mobile des moyens d'actionnement doivent lui conférer les propriétés électriques et mécaniques décrites ultérieurement.

Il est possible que l'électrode fixe coopère avec une ou plusieurs électrodes mobiles.

Pour éviter des risques de court-circuit, en position de travail l'électrode mobile est espacée de l'électrode fixe par au moins un matériau électriquement isolant.

La jambe peut être conçue suffisamment rigide de manière qu'en position de travail l'électrode mobile soit sans contact mécanique avec le support.

La partie mobile des moyens d'actionnement électrostatiques peut être en contact avec le liquide ou sans contact avec le liquide.

Toujours dans le souci d'éviter un court-circuit, il possible que la partie mobile des moyens d'actionnement électrostatiques vienne, en position de travail, en contact mécanique contre au moins une butée diélectrique.

Pour améliorer l'efficacité de la commande des moyens d'actionnement électrostatiques, le dispositif optique peut comporter en outre des moyens d'asservissement des moyens d'actionnement électrostatiques en fonction de l'espacement existant entre l'électrode mobile et l'électrode fixe.

Pour faciliter l'alimentation en énergie de la partie mobile des moyens d'actionnement électrostatiques, il est possible que le dispositif optique comporte, en outre, au moins une jambe sacrifiée fixe dont l'extrémité libre est solidaire du support, cette jambe sacrifiée fixe étant destinée à être reliée à une source d'énergie et à alimenter par le pied auquel elle est reliée au moins une électrode mobile d'une partie mobile.

Pour éviter des risques de fuite, le film de la membrane peut être ancré au support par des moyens d'ancrage mécaniques.

Le dispositif optique peut être une lentille liquide à focale variable, une lentille liquide à correction d'aberrations optique en optique adaptative, un miroir à membrane déformable.

La présente invention concerne également un procédé de réalisation d'un dispositif optique à membrane déformable dans lequel :
- sur un substrat initial on réalise un premier moule sacrificiel,
- on dépose un film déformable de la membrane sur le moule sacrificiel de manière à ce qu'une zone d'ancrage périphérique du film soit ancrée sur le support,
- on réalise au moins une piste conductrice qui court sur le film destinée à alimenter en énergie au moins une partie mobile conductrice réalisée ultérieurement de moyens d'actionnement électrostatiques,
- on réalise un second moule sacrificiel pour la partie mobile des moyens d'actionnement électrostatiques, ce second moule sacrificiel s'étendant sur le film et sur le substrat, la partie mobile devant avoir un pied solidaire du film de la membrane dans une zone intermédiaire située entre la zone d'ancrage et une zone centrale,
- on dépose la partie mobile sur le second moule sacrificiel,
- on élimine le second moule sacrificiel de manière à libérer une jambe de la partie mobile possédant une extrémité libre et une extrémité reliée au pied,
- on protège la partie mobile et le film avec un dispositif de protection rapporté sur le substrat,
- on réalise une électrode fixe en regard de la partie mobile,
- on élimine le premier moule sacrificiel grâce à un accès à travers le substrat ou la membrane,
- on emprisonne un liquide entre le film et le dispositif de protection ou à la place du premier moule sacrificiel.

On peut relier électriquement la piste conductrice par l'intermédiaire d'un trou métallisé traversant le substrat initial à un plot de contact situé à l'opposé du film par rapport au substrat initial.

Lorsque la partie mobile se trouve dans le liquide, on peut réaliser l'électrode fixe sur le dispositif de protection qui est un substrat transparent muni de parois délimitant une cuvette pour le liquide et fixé au substrat initial par les parois.

Lorsque la partie mobile se trouve dans le liquide, le trou dans le substrat servant à éliminer le premier moule sacrificiel aura de préférence au moins la taille de la zone centrale.

En variante, lorsque la partie mobile se trouve à l'opposé du liquide par rapport au film, on peut réaliser l'électrode fixe sur une couche diélectrique que porte le substrat initial avant de déposer le film de manière à ce que le film revête l'électrode fixe.

Lorsque la partie mobile se trouve à l'opposé du liquide par rapport au film, le dispositif de protection est de préférence un capot transparent.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
les figures 1A à 1F montrent différentes variantes d'un dispositif optique selon l'invention en position de repos et en position de travail ;
les figures 2A, 2B montrent des détails de l'ancrage de la membrane au support ;
les figures 3A à 3I montrent en vue de dessus des membranes de dispositifs optiques et la région de solidarisation des pieds de leurs parties mobiles ;
les figures 4A à 4E montrent différentes variantes de parties mobiles de la membrane ;
les figures 5A à 5D montrent en vue de dessus différentes variantes de membrane avec des zones géographiques particulières en plus des zones d'ancrage, intermédiaire et centrale ;
les figures 6A à 6Q montrent en coupe différents modes de réalisation d'une membrane du dispositif optique selon l'invention ;
les figures 7A, 7B montrent des membranes de dispositifs optiques selon l'invention qui ne sont pas circulaires ;
les figures 8A, 8B montrent un dispositif optique selon l'invention en position de repos et en position de travail dans lequel la membrane est convexe au repos ;
les figures 9A, 9B montrent une membrane d'un dispositif optique selon l'invention dont les jambes de ses parties mobiles sont repliées et la figure 9C montre une membrane avec une jambe dont l'extrémité libre est au niveau de la zone centrale ;
les figures 10A, 10B permettent de comparer une partie mobile dont la jambe est ramifiée à une partie mobile dont la jambe est unique ;
la figure 11 montre un dispositif optique selon l'invention équipé de moyens d'asservissement des moyens d'actionnement électrostatiques ;
les figures 12A à 12F illustrent différentes caractéristiques de la partie mobile et de l'électrode mobile d'une membrane d'un dispositif optique selon l'invention et de son alimentation en énergie ;
les figures 13A à 130 illustrent différentes étapes de réalisation d'un dispositif optique selon l'invention dans lequel la partie mobile des moyens d'actionnement électrostatiques est en contact avec le liquide ;
les figures 14A à 14M illustrent différentes étapes de réalisation d'un dispositif optique selon l'invention dans lequel la partie mobile des moyens d'actionnement électrostatiques est sans contact avec le liquide ;
les figures 15A, 15B déjà décrites, montrent des lentilles liquides de l'art antérieur.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

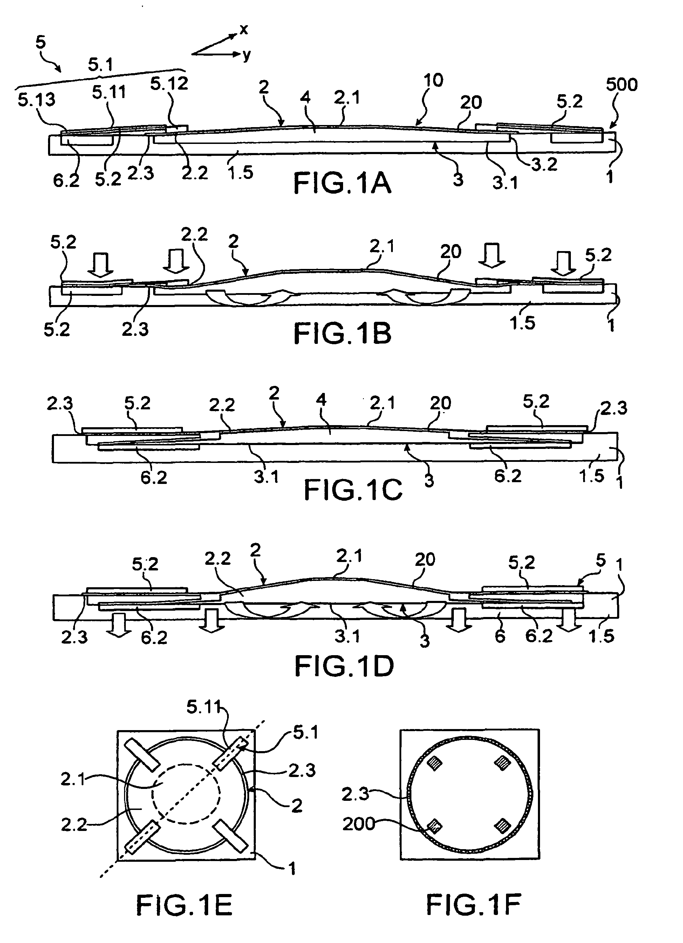

On va maintenant s'intéresser à deux modes de réalisation de la membrane 2 d'un dispositif optique objet de l'invention, en se référant aux figures 1A, 1B, 1C, 1D, 1E 1F. La membrane 2 comporte un film 20 souple 20 possédant au moins trois zones distinctes parmi lesquelles une zone d'ancrage 2.3 périphérique destinée à être ancrée de manière étanche sur un support 1. Il y a également une zone centrale 2.1 que l'on cherche à déformer pour ajuster le rayon de courbure de la membrane et faire varier la distance focale si le dispositif optique est une lentille liquide 4, pour corriger les aberrations optiques s'il s'agit d'une lentille à correction d'aberrations optiques ou pour faire varier un angle de réflexion s'il s'agit d'un miroir. Enfin, on distingue une zone intermédiaire 2.2 entre la zone centrale 2.1 et la zone d'ancrage 2.3 périphérique.

Le support 1 et la membrane 2 emprisonnent un liquide 4. Dans l'exemple le support 1 est un substrat doté d'une cuvette 3 destinée à renfermer un volume constant du liquide 4. Le support 1 s'étend selon un plan principal x,y. La cuvette 3 possède un fond 3.1 et un bord 3.2.

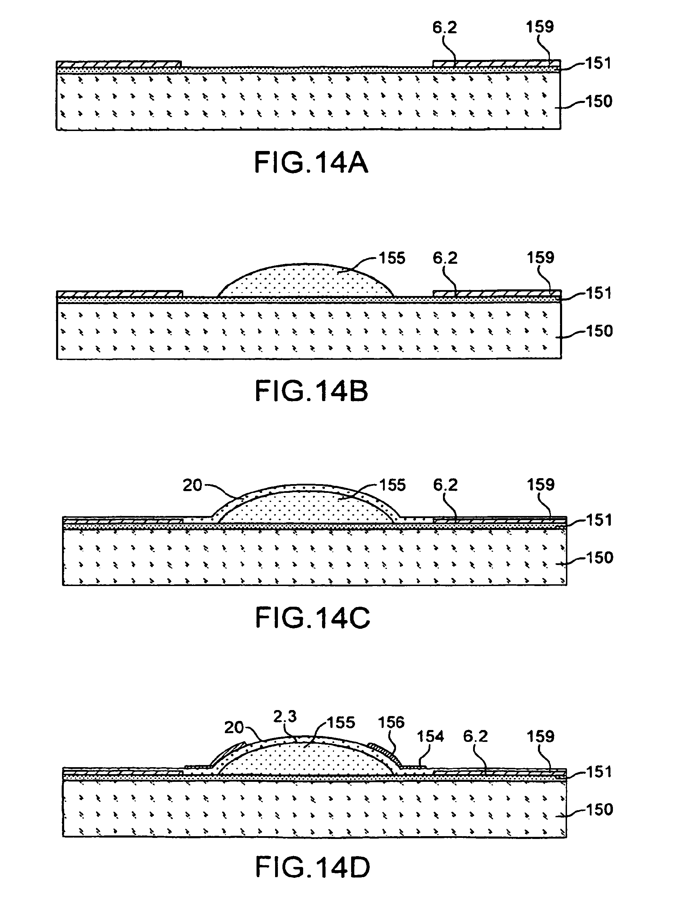

Lorsque le dispositif optique est une lentille 10, un faisceau optique (non représenté) est destiné à traverser la lentille 10, en se propageant à travers la membrane 2, le liquide 4 et le support 1 au niveau du fond 3.1 de la cuvette 3. La cuvette 3 n'est pas nécessaire, le support 1 pouvant être un substrat sensiblement plan comme décrit aux figures 14A à 14M.

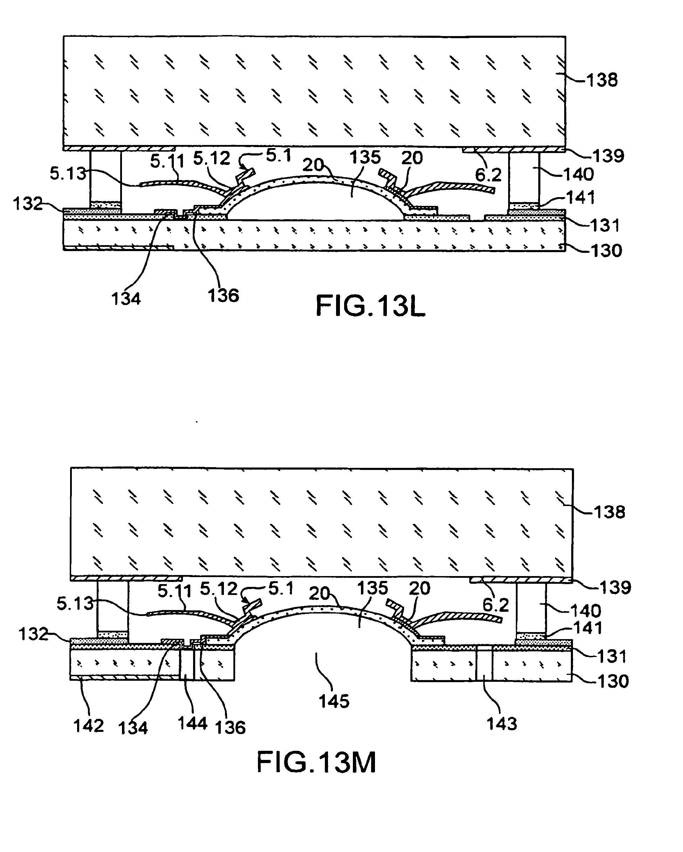

Le fond 3.1 est transparent pour le faisceau optique utilisé. Le support 1 peut être monolithique comme sur les figures 1 ou être formé par un cadre assemblé à un fond comme sur la figure 13M. Le faisceau optique traverse la membrane 2 au niveau de la zone centrale 2.1 encore appelée champ optique. La zone centrale 2.1 est transparente. Il est bien évident que la zone utile optiquement utilisée dans la zone centrale peut être inférieure à toute la surface de la zone centrale 2.1.

Par la suite, on a employé parfois l'expression zone centrale 2.1 parfois l'expression champ optique pour cette zone de la membrane 2.

Le liquide 4, dont le volume est constant, peut être du carbonate de propylène, de l'eau, un liquide d'indice, une huile optique ou encore un liquide ionique. Il est choisi notamment pour ses propriétés optiques dans le cas d'une lentille liquide, telles que son indice optique pour un dispositif optique fonctionnant en transmission.

Si le dispositif optique était un miroir à membrane déformable, la membrane serait réfléchissante, puisqu'une telle membrane st destinée à réfléchir un faisceau optique incident. Le champ optique ne serait pas transparent.

La membrane 2 comporte un film 20 souple faisant office de barrière entre le liquide 4 et un milieu fluide se trouvant de l'autre côté de la barrière par rapport au liquide 4. Ce fluide peut être tout simplement de l'air ou un autre gaz ou même un autre liquide. La membrane 2, au moins dans la zone centrale 2.1, a une face principale en contact avec le liquide 4 et une autre face en contact avec le fluide, cette autre face forme un dioptre. On choisit le matériau de la membrane 2 de manière à ce qu'elle puisse résister à des sollicitations extérieures telles que la dilatation du liquide 4, les chocs, le poids du liquide dû à la gravité, sans dégrader la membrane de manière irréversible.

La membrane 2 est représentée circulaire sur les figures 1E, 1F mais d'autres formes sont envisageables.

La membrane 2 comporte au moins une partie mobile 5.1 de moyens d'actionnement électrostatiques 5 destinés à déformer la membrane 2 lors de leur actionnement. Les moyens d'actionnement électrostatiques 5 sont formés d'un ou plusieurs actionneurs électrostatiques 500 comportant chacun une électrode fixe 6.2 solidaire du support 1 et une partie mobile 5.1 portée par le film 20 de la membrane 2 intégrant une électrode mobile 5.2.

Chaque partie mobile 5.1 comporte une jambe 5.11 se terminant à une extrémité par un pied 5.12 solidarisé au film 20 au niveau d'une région de solidarisation 200 se trouvant dans la zone intermédiaire 2.2 de la membrane 2. La jambe 5.11 se termine à l'autre extrémité par au moins une extrémité libre 5.13 et mobile. La jambe 5.11 intègre au moins du côté de son extrémité libre 5.13 une électrode mobile 5.2. L'électrode mobile 5.2 peut être confondue avec la jambe ou être un des constituants de la jambe. La jambe 5.11 se projette depuis le pied 5.12 vers le bord de la membrane 2. La jambe 5.11, hormis son pied 5.12, est sensiblement parallèle à la membrane 2. Son extrémité libre 5.13 peut dépasser le bord de la membrane 2 mais ce n'est pas une obligation comme illustré aux figures 1C, 1D. Plus généralement son extrémité libre 5.13 est située à l'opposé de la zone centrale 2.1 par rapport au pied 5.12. Au repos, l'extrémité libre 5.13 peut être en contact ou non avec le support 1. Dans la mesure où les moyens d'actionnement électrostatiques 5 comportent plusieurs actionneurs électrostatiques 500, ces derniers peuvent être répartis sensiblement régulièrement autour de la membrane 2. Cela permet que la déformation de la zone centrale 2.1 de la membrane 2 soit la plus homogène possible.

Pour ce faire, les actionneurs électrostatiques 500 seront placés, de préférence, de façon symétrique afin de respecter la symétrie du champ optique.

Toutefois, lorsque pour une application en optique adaptative, cette propriété n'est pas recherchée et la localisation des pieds 5.12 ne respectera pas la symétrie du champ optique.

Dans l'exemple d'une membrane 2 circulaire, comme illustré sur les figures 1E, 1F, les jambes 5.11 sont disposées radialement. Sur la figure 1F on a représenté les régions solidarisation 200 des pieds 5.12 sur le film 20 de la membrane 2.

Lors de l'actionnement des moyens d'actionnement électrostatiques 5, d'une position de repos à une position de travail, l'électrode mobile 5.2 est attirée par l'électrode fixe 6.2. Sur les figures 1, la figure 1A et la figure 1C correspondent à la position de repos et les figures 1B, 1D correspondent à une position de travail.

L'actionnement se produit lorsqu'une différence de potentiel de valeur appropriée est appliquée entre l'électrode mobile 5.2 et l'électrode fixe 6.2 d'un actionneur 500. Cette différence de potentiel est appelée tension d'actuation. L'électrode mobile 5.2 est placée en regard de l'électrode fixe 6.2. La jambe 5.11 sur laquelle se trouve l'électrode mobile 5.2 est suffisamment déformable pour pouvoir se courber lors de l'actionnement. L'électrode mobile 5.2 peut venir accoster ou se plaquer sur un isolant 7 la séparant de l'électrode fixe 6.2, le mouvement de l'électrode mobile 5.2 et donc de la jambe 5.11 se faisant progressivement et presque linéairement avec la tension appliquée. Cet actionnement est qualifié d'actionnement de type « zipping » ou à fermeture progressive ou à fermeture éclair ou par glissière.

En variante l'électrode mobile 5.2 peut seulement se rapprocher de l'électrode fixe 6.2 sans qu'il y ait cet accostage.

Lors de l'actionnement, le pied 5.12 par lequel se termine la jambe 5.11 transmet un effort au film 20 de la membrane 2 ce qui permet un déplacement de celle-ci dans la zone intermédiaire 2.2, ce déplacement chasse le liquide 4 se trouvant sous la membrane 2 au niveau de la région de solidarisation 200 du pied 5.12 et provoque une déformation de la zone centrale 2.1 de la membrane 2 et donc un changement du rayon de courbure du dioptre. Cette déformation vise à faire varier la distance focale de la membrane 2, à corriger les aberrations ou à déformer le miroir selon l'application de la membrane.

Chaque partie mobile 5.1 se trouve soit sur la face de la membrane 2 en contact avec le liquide 4 comme illustré sur les figures 1C, 1D soit sur l'autre face comme illustré sur les figures 1A, 1B.

La fixation mécanique des parties mobiles 5.1 sur le film 20 de la membrane 2 a pour but d'améliorer l'efficacité de l'actionnement par rapport à un système où les moyens d'actionnement électrostatiques viennent comprimer localement la membrane 2. Par efficacité, on entend que l'on obtient une plus grande déformation c'est-à-dire une plus grande variation de distance focale pour un apport d'énergie donné.

On s'arrange pour que l'électrode fixe 6.2 et l'électrode mobile 5.2 ne viennent pas en contact direct l'une contre l'autre ce qui provoquerait un court-circuit.

Lorsque la jambe 5.11 et l'électrode mobile 5.2 qui lui est intégrée se trouvent sur la face de la membrane 2 opposée au liquide 4, la membrane 2 peut servir de diélectrique pour isoler les deux électrodes 5.2, 6.2. En variante ou en combinaison, les deux électrodes 5.2, 6.2 peuvent rester en position de travail, éloignées l'une de l'autre par le milieu fluide se trouvant de l'autre côté de la membrane 2 par rapport au liquide 4. Dans ce cas, la jambe 5.11 est suffisamment rigide pour qu'elle reste « en l'air ». Elle ne vient se plaquer physiquement sur rien en position de travail.

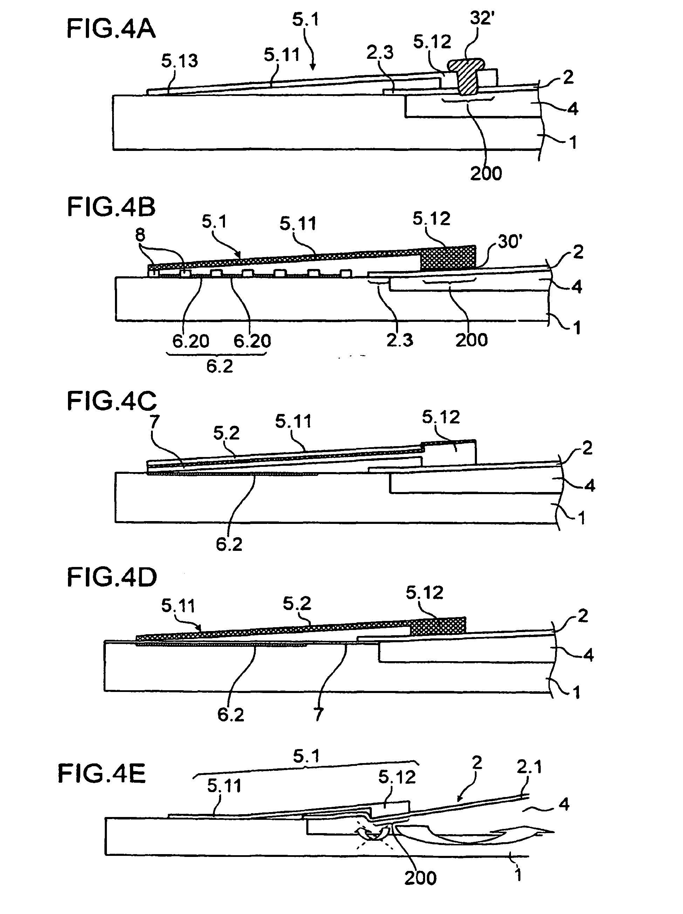

Il est bien sûr possible que l'isolant 7 puisse épouser la forme d'une partie isolante qui revêt l'électrode mobile 5.2, l'électrode fixe 6.2 ou les deux. Cette partie isolante 7 peut être embarquée sur la jambe 5.11 et participer ou non à sa rigidité comme sur la figure 4C. La partie isolante 7 peut concerner l'électrode fixe 6.2 comme sur la figure 4D. Autrement dit en plus du fluide ambiant chassé lors de l'attraction électrostatique de l'électrode mobile 5.2 au moins un autre diélectrique sépare en permanence les deux électrodes 5.2, 6.2. On suppose que sur la figure 4D, la jambe 5.11 de la partie mobile 5.1 se limite à l'électrode mobile 5.2 et que sur la figure 4B l'électrode mobile 5.2 et toute la partie mobile 5.1, c'est-à-dire pied 5.12 et jambe 5.11 sont confondus. Sur la figure 4C, la jambe 5.11 comporte à la fois l'électrode mobile 5.2 et la partie isolante 7 en tant que revêtement. La partie isolante 7 peut occuper la plus grande partie de la partie mobile 5.1 et donner sa forme à la jambe 5.11.

L'électrode mobile 5.2 peut être réalisée dans un matériau métallique tel que le nitrure de titane, l'or, un empilement chrome/or, l'aluminium. L'épaisseur de l'électrode mobile 5.2 se situe dans une fourchette allant de quelques nanomètres à quelques dizaines de micromètres environ. Concernant le diélectrique de la partie isolante 7, si elle est embarquée sur la jambe 5.11, on peut utiliser de nombreux matériaux et en particulier les matériaux minéraux diélectriques employés pour réaliser la membrane 2 tels que le dioxyde de silicium ou le nitrure de silicium. L'épaisseur de matériau diélectrique de la jambe 5.11 se situe dans une fourchette allant de quelques nanomètres à quelques dizaines de micromètres environ. Si l'électrode mobile 5.2 et la jambe 5.11 sont confondues, une même fourchette d'épaisseur peut être conservée.

Lorsque la partie mobile 5.1 se trouve baignée par le liquide 4, ce dernier peut être diélectrique. On le choisira pour qu'il ait une tension de claquage et une constante diélectrique appropriées. Dans le cas évoqué plus haut et illustré aux figures 1A, 1B, le liquide 4 n'a pas besoin d'avoir des propriétés diélectriques.

Une autre possibilité est de prévoir une ou plusieurs butées diélectriques 8 visant à empêcher que les électrodes fixe et mobile 5.2, 6.2 entrent en contact mécanique direct. On peut se référer à la figure 4B. Les butées diélectriques 8 sont portées par le support 1 au niveau de l'électrode fixe 6.2, mais elles auraient pu être portées par la jambe 5.11 de la partie mobile 5.1 ou être réparties entre le support 1 et la jambe 5.11. Sur cette figure 4B, l'électrode fixe 6.2 comporte plusieurs portions 6.20 et plusieurs butées diélectriques 8 qui forment une succession alternée. Ces portions d'électrodes 6.20 et ces butées 8 peuvent circulaires ou en arc de cercle et concentriques.

On va maintenant décrire de manière plus détaillée la membrane 2 en commençant par son film 20.

Dans une version minimaliste, la membrane ou plus précisément son film 20 comporte trois zones comme on l'a déjà dit. La zone centrale 2.1, correspondant au champ optique dans une application de lentille. Le film 20 est formé d'au moins une couche continue 20.1 qui s'étend sur toute sa surface.

Le dimensionnement de la membrane 2 est guidé par le comportement qu'elle aura dans la zone centrale 2.1, puisque la variation de la distance focale ou de la courbure du dispositif optique dépend directement du déplacement de la zone centrale 2.1.

La zone centrale 2.1 de la membrane 2 est suffisamment souple et élastique pour pouvoir se déformer de manière réversible lorsqu'elle est activée par le déplacement des pieds 5.12 des parties mobiles 5.1 des actionneurs électrostatiques 500.

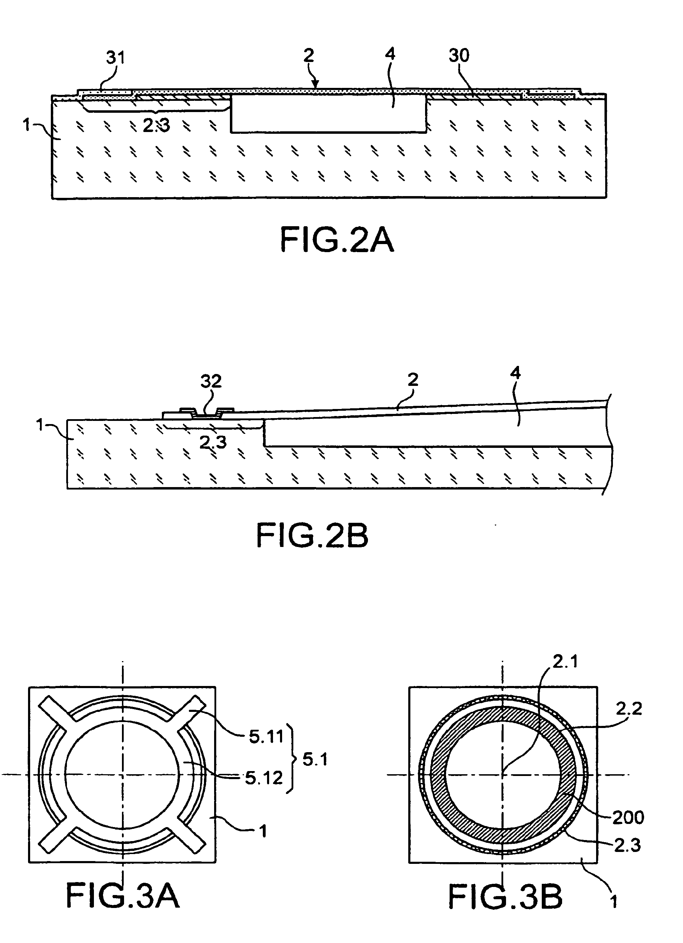

La zone d'ancrage 2.3 de la membrane 2 doit être fixée de manière étanche au support 1 de manière à éviter toute fuite de liquide 4 ou toute entrée de fluide environnant sous la membrane 2. L'adhérence entre la zone d'ancrage 2.3 et le support 1 est un paramètre déterminant pour cette zone. Son adhérence est suffisante pour supporter les efforts induits par les déplacements de la zone centrale 2.1 et de la zone intermédiaire 2.2 tout en assurant l'étanchéité. Pour atteindre l'adhérence recherchée, il est possible d'insérer un primaire d'adhérence 30 entre la zone d'ancrage 2.3 de la membrane 2 et le support 1 comme illustré sur la figure 2A. Sur cette figure, le primaire d'adhérence 30 ne s'étend que partiellement sur la zone d'ancrage 2.3 de la membrane 2. Il est tout à fait possible qu'il s'étende sur toute la zone d'ancrage 2.3. En variante ou en combinaison, il est possible de revêtir la zone d'ancrage 2.3 au moins partiellement avec un revêtement 31 qui s'étend aussi sur le support 1 au-delà du film 20 de la membrane 2 comme illustré sur la figure 2A. Une autre configuration est montrée sur la figure 2B, on prévoit un dispositif de fixation mécanique 32 tel un ou plusieurs rivets 32 qui maintiennent la zone d'ancrage 2.3 au support 1, ils traversent la zone d'ancrage 2.3 et pénètrent dans le support 1.

Afin d'optimiser l'adhérence de la zone d'ancrage 2.3 sur le support 1, il est possible de prévoir un traitement préalable du support 1 avant la fixation. On pourra, par exemple, réaliser un traitement de surface avec un plasma par exemple d'oxygène ou bien effectuer un dépôt avec une couche de matériau primaire d'adhérence. Sur les figures 2, les parties mobiles 5.1 des moyens d'actionnement électrostatiques n'ont pas été portées pour ne pas surcharger les figures.

On va maintenant s'intéresser à la zone intermédiaire 2.2. C'est dans cette zone intermédiaire que se trouvent les régions de solidarisation 200 des parties mobiles 5.1 des moyens d'actionnement électrostatiques 5. La membrane 2 peut assurer une continuité avec les pieds 5.12 des parties mobiles 5.1 comme illustré sur les figures 1C, 1D ou au contraire les pieds 5.12 peuvent être rapportés sur le film 20 de la membrane 2 comme illustré sur les figures 1A, 1B. Dans les deux cas, on peut définir sur le film 20 la région de solidarisation 200, elle correspond à l'emprise qu'à un pied 5.12 de partie mobile 5.1 sur le film 20. La zone intermédiaire 2.2 peut être au moins localement plus rigide que la zone centrale 2.1 mais ce n'est pas une obligation. La région de solidarisation peut être morcelée en portions 200.1.

Le nombre de portions 200.1 de la région de solidarisation 200 ne correspond pas forcément au nombre de parties mobiles 2.1 comme illustré sur les figures 3A à 3F. Les figures 3A à 3F montrent alternativement d'une part une membrane 2 d'un dispositif optique selon l'invention, vue de dessus avec le film 20, les parties mobiles 5.1 et d'autre part seulement les différentes parties du film 20 de la membrane 2 illustrée sur la figure précédente et notamment la région de solidarisation 200.

Sur la figure 3A, on distingue quatre parties mobiles 5.1 avec quatre jambes 5.11 radiales mais un seul pied 5.12 commun à toutes les jambes 5.11. La région de solidarisation 200 est continue en forme de couronne comme illustré sur la figure 3B.

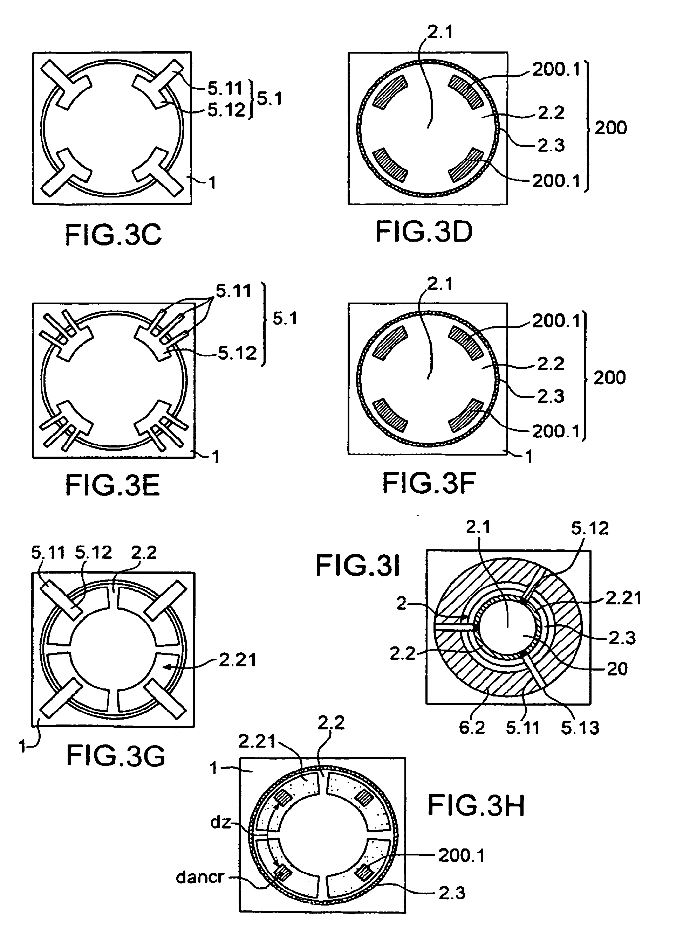

Sur les figures 3C, 3D il y a toujours quatre parties mobiles 5.1 avec quatre jambes 5.11 radiales mais chaque jambe 5.11 coopère avec un pied 5.12 qui lui est propre. La région de solidarisation 200 est subdivisée en quatre portions de couronne 200.1.

Sur les figures 3E, 3F il y a maintenant douze parties mobiles 5.1 et donc douze jambes 5.11, réparties en quatre groupes, chaque groupe ayant un pied commun 5.12. La région de solidarisation 200 est subdivisée en quatre portions de couronne 200.1 comme dans le cas précédent.

Les exemples donnés ne sont pas limitatifs, on pourrait utiliser plus ou bien moins de parties mobiles.

Préférentiellement le nombre de parties mobiles 5.1 et leur localisation sont choisis de façon à respecter les symétries de la membrane 2 symbolisées par les axes en pointillés sur les figures 3A à 3F.

Toutefois la localisation des parties mobiles 5.1 peut ne pas respecter cette symétrie si la zone intermédiaire 2.2 est plus rigide que la zone centrale 2.1 et que la zone d'ancrage 2.3 comme illustré sur les figures 3G à 3I. Sur les figures 3G et 3H la zone intermédiaire 2.2 comporte une région renforcée 2.21 morcelée en portions renforcées distinctes 2.211. La rigidité de la zone intermédiaire 2.2 est plus importante que la zone centrale 2.1. Les portions renforcées 2.211 sont des portions de couronne. Il y a quatre parties mobiles 5.1 radiales chacune étant dotée d'un pied 5.12. La région de solidarisation 200 des pieds 5.12 se trouve au niveau d'une portion renforcée 2.211, et plus particulièrement dans un endroit sensiblement central de la portion renforcée 2.211. La surface d'une région de solidarisation 200 est inférieure à celle d'une portion renforcée 2.211. Sur la figure 3I, il y a trois parties mobiles 5.1 décalées sensiblement de 120°, elles possèdent chacune un pied 5.12 qui leur est propre, la région renforcée 2.21 est continue et prend la forme d'une couronne.

La région renforcée 2.21 rend le film 20 localement suffisamment rigide pour répercuter sur le liquide 4 la pression appliquée par les pieds 5.12 et donc générer les déplacements du liquide 4 recherchés.

La région renforcée 2.21 qui cerne la zone centrale 2.1 permet ainsi d'augmenter les déplacements de liquide 4 pour une force d'actionnement donnée des moyens d'actionnement électrostatiques 5.

Dans la mesure où la partie mobile 5.1 des moyens d'actionnement électrostatiques 5 est rapportée sur la membrane 2, la notion d'adhérence entre le pied 5.12 et le film 20 est essentielle, surtout si le pied 5.12 tire sur le film 20 et que la partie mobile 5.1 est placée sous la membrane 2 dans le liquide 4.

Dans le cas où l'adhérence de la membrane 2 est suffisante, elle peut à elle seule garantir la fixation mécanique recherchée pour le pied 5.12. Dans le cas contraire, on pourra introduire un primaire d'adhérence 30' entre le pied 5.12 et la région de solidarisation 200 comme illustré sur la figure 4B. Une autre configuration est d'utiliser un dispositif de fixation mécanique du pied tel un ou plusieurs rivets 32' comme le montre la figure 4A. Le rivet 32' représenté traverse le pied 5.12 et le film 20. Il n'ya pas de risque de fuite si le rivet 32' remplit sa fonction qui est d'améliorer la fixation entre la membrane 2 et le pied 5.12.

Au niveau de la région de solidarisation 200 le déplacement de la membrane 2 lors de l'actionnement des moyens d'actionnement électrostatiques 5 induit des mouvements du liquide 4 à l'origine du fonctionnement du dispositif optique incluant la membrane 2. La surface de la région de solidarisation 200 et sa répartition sur la membrane 2 sont autant de paramètres déterminants pour le déplacement de la zone centrale 2.1.

Le comportement mécanique de la membrane 2 dépend notamment de la surface de la région de solidarisation 200 et de la région renforcée 2.21 si elle existe. On s'arrange pour que la rigidité de la membrane 2 dans le champ optique 2.1, c'est à dire les paramètres E (module d'Young du matériau constitutif de la zone centrale 2.1), v (coefficient de Poisson du matériau constitutif de la zone centrale 2.1), h (épaisseur de la zone centrale 2.1) et R (rayon de la zone centrale 2.1) soient en accord avec ces régions et avec la force que développent les moyens d'actionnement électrostatiques 5. En effet, la pression exercée par le liquide 4 sur le champ optique 2.1 multipliée par la surface totale de la membrane 2 en contact avec le liquide 4 est égale en première approximation, en considérant le liquide 4 comme incompressible, à la force développée par les moyens d'actionnement électrostatiques 5. Une telle approche permet de dégager un ordre de grandeur de la force à développer par les moyens d'actionnement électrostatiques.

Le comportement mécanique de la membrane 2 dans le champ optique 2.1 dépend donc de la flèche maximale h de la membrane 2, de la force appliquée par les moyens d'actionnement électrostatiques 5, de leur débattement et éventuellement de la surface de fixation qui correspond à la surface de la région de solidarisation 200. Plus particulièrement la rigidité en flexion de la membrane 2 dans le champ optique qui dépend des paramètres E, v, h, R doit être adaptée avec la surface de solidarisation et la force exercée par les moyens d'actionnement électrostatiques.

Lorsque la région de solidarisation 200 comporte plusieurs portions 200.1, la distance d_{z} séparant deux portions de solidarisation 200.1 consécutives qui se succèdent autour de la zone centrale 2.1 ne doit pas être trop importante au risque de voir apparaître des déformations locales non désirées du film 20 de la membrane 2 pouvant perturber le fonctionnement du dispositif optique intégrant la membrane 2. Enfin la distance d_{ancr} entre la région de solidarisation 200 des pieds 5.12 et la zone d'ancrage 2.3 au support 1 est également importante. Cette distance d_{ancr} ne doit pas être trop petite devant la rigidité de la zone centrale 2.1 car sinon le débattement des moyens d'actionnement électrostatiques 5 sont entravés et le déplacement du liquide 4 n'est pas optimum. Cette distance d_{ancr} ne doit pas être trop grande devant la rigidité de la zone centrale 2.1 car sinon trop de liquide 4 sera chassé vers le bord de la membrane 2 et cela se fait au détriment de la quantité de liquide 4 chassé vers la zone centrale 2.1. La figure 4E illustre ce dernier cas. Typiquement un compromis sera atteint lorsque la rigidité en flexion de la région de solidarisation 200 est supérieure à la rigidité en flexion de la zone centrale 2.1.

Si une région renforcée 2.21 a été prévue ce que l'on vient de dire pour la région de solidarisation 200 s'applique à la région renforcée 2.21.

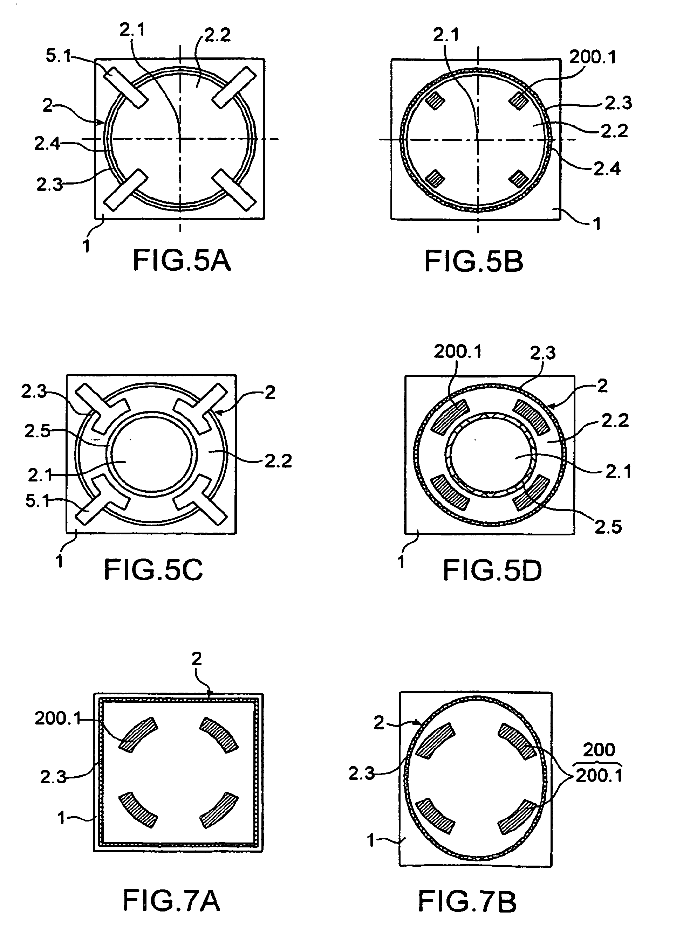

Afin de faciliter le déplacement de la région de solidarisation 200 et/ou de la région renforcée 2.21 si elle existe, une zone périphérique à souplesse accrue 2.4 plus souple que la zone centrale 2.1 peut être aménagée entre la zone d'ancrage 2.3 et la zone intermédiaire 2.2. Cette zone périphérique à souplesse accrue 2.4 peut être continue ou morcelée en plusieurs portions. On peut se référer aux figures 5A, 5B qui montrent cette zone périphérique à souplesse accrue 2.4 continue en forme de couronne.

Afin d'uniformiser la déformation du film 20 de la membrane 2 dans la zone centrale 2.1 et d'augmenter ainsi les performances du dispositif optique intégrant la membrane 2, il est possible de prévoir une zone de renfort 2.5 insérée entre la zone centrale 2.1 et la zone intermédiaire 2.22. Cette zone de renfort 2.5 a une rigidité supérieure à celle de la zone centrale 2.1. Les pieds 5.12 des parties mobiles 5.1 ne la sollicitent pas directement puisqu'elle n'est pas dans la zone intermédiaire 2.2. Elle est de préférence continue en forme de couronne comme illustré sur les figures 5C, 5D, mais elle pourrait être morcelée en plusieurs portions.

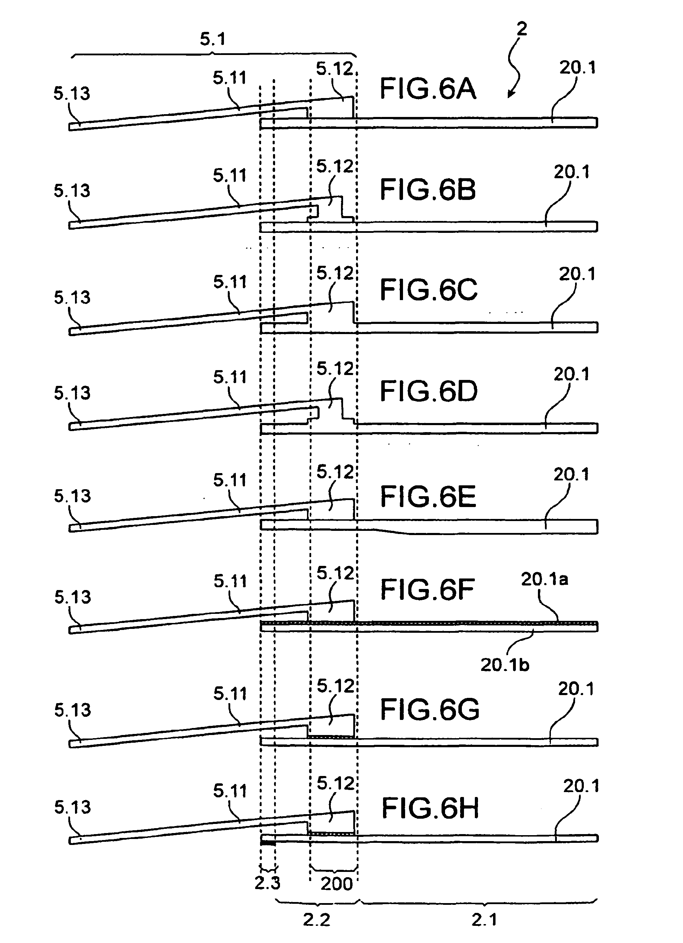

On va maintenant, en se référant aux figures 6A à 6Q, examiner différentes structures de membrane 2 de dispositifs optiques selon l'invention. Ces différentes configurations sont non exhaustives. Ces figures montrent des coupes de la membrane 2. Sur ces figures, la partie mobile 5.1 des moyens d'actionnement électrostatiques 5 est sus-jacente au film 20 de la membrane 2. Il est bien sûr possible que cette partie mobile 5.1 soit sous-jacente au film 20 de la membrane 2 et des configurations équivalentes peuvent être envisagées. Le profil de la membrane 2 influe fortement sur la forme de la zone centrale 2.1, en faisant varier les épaisseurs des différentes zones on peut optimiser la forme du dioptre de la lentille qui possède une telle membrane 2.

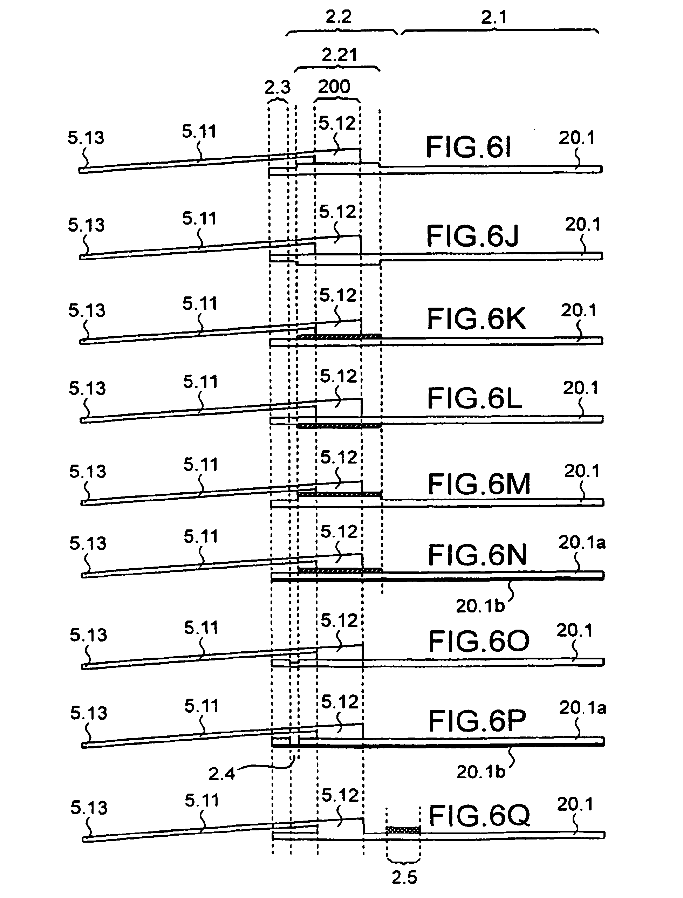

La membrane 2 peut avoir un film 20 monocouche comme sur les figures 6A à 6E, 6I, 6J, 6O ou multicouche comme sur les figures 6F à 6H, 6K à 6N, 6P, 6Q mais dans tous les cas une couche 20.1 du film 20 s'étend de manière continue sur toute sa surface. Les risques de fuites sont réduits puisqu'on ne va pas assembler plusieurs parties placées les unes à côté des autres à la manière d'un patchwork comme dans l'art antérieur. Sur les figures 6A, 6B, la couche continue 20.1 de la membrane 2 occupe toute la surface de la membrane 2. Une interface existe entre le film 20 de la membrane 2 et le pied 5.12 de la partie mobile 5.1 des moyens d'actionnement électrostatiques 5, le pied 5.12 étant plus massif sur la figure 6A que sur la figure 6B.

Sur les figures 6C, 6D, la couche continue 20.1 du film 20 de la membrane 2 occupe toute la surface de la membrane 2. Le pied 5.12 de la partie mobile 5.1 des moyens d'actionnement électrostatiques 5 est d'un seul tenant avec la couche continue 20.1. Le pied 5.12 est plus massif sur la figure 6C que sur la figure 6D. Le film 20 est d'épaisseur sensiblement constante sur toute la surface de la membrane 2 sur les figures 6A à 6D. Sur la figure 6E le film 20 est monocouche mais son épaisseur varie. Il est plus épais au centre de la zone centrale 2.1, son épaisseur se réduit en s'éloignant du centre de la zone centrale 2.1, dans la zone intermédiaire 2.2 et dans la zone d'ancrage 2.3 son épaisseur est sensiblement constante et cette épaisseur correspond sensiblement à l'épaisseur la plus faible de la zone centrale 2.1. En faisant varier l'épaisseur de la zone centrale 2.1 de la sorte on peut modifier sa déformée et donc changer la forme du dioptre de la lentille intégrant la membrane 2.

Sur la figure 6F, la couche continue est formée d'un empilement de deux sous-couches 20.1a, 20.1b. Ces deux sous-couches 20.1a, 20.1b sont d'épaisseur sensiblement constante.

Sur la figure 6G, le film 20 de la membrane 2 est multicouche au niveau de la région de solidarisation 200 des pieds 5.12 des parties mobiles 5.1 des moyens d'actionnement électrostatiques 5 et monocouche ailleurs.

Sur la figure 6H, le film 20 de la membrane 2 est multicouche au niveau de la région de solidarisation 200 des pieds 5.12 des parties mobiles 5.1 des moyens d'actionnement électrostatiques 5 et au niveau de la zone d'ancrage 2.3, elle est monocouche ailleurs. Sur les figures 6F à 6H, les différentes couches ont une épaisseur sensiblement constante.

Sur les figures 6I et 6J on a représenté une région renforcée 2.21 dans la zone intermédiaire 2.2 au niveau de la région de solidarisation 200 des pieds 5.12. Le film 20 de la membrane 2 est monocouche et son épaisseur est augmentée au niveau de la région renforcée 2.21. La zone centrale 2.1 et la zone d'ancrage 2.3 ont sensiblement la même épaisseur constante. Sur la figure 6I, la région renforcée 2.21 s'étend à l'opposé de la face en contact avec le liquide 4 et sur la figure 6J c'est l'inverse.

Sur les figures 6K et 6L, la région renforcée 2.21 est aussi épaissie par rapport à la zone centrale 2.1 et à la zone d'ancrage 2.3 mais maintenant elle est multicouche. Toutefois la couche continue 20.1 qui s'étend sur toute la surface du film 20 de la membrane 2 a une épaisseur sensiblement constante.

Le film 20 de la membrane 2 de la figure 6M est comparable à celui de la figure 6K avec une région renforcée 2.21 multicouche à l'exception du fait que la couche continue 20.1 qui s'étend sur toute la surface du film 20 de la membrane 2 est épaissie au niveau de la région renforcée 2.21. La région renforcée 2.21 est tournée à l'opposé de la face devant venir en contact avec le liquide 4 mais elle aurait pu être tournée du côté de la face devant venir en contact avec le liquide 4.

Sur la figure 6N, la couche continue 20.1 du film 20 est formée d'un empilement de sous couches 20.1a, 20.1b, son épaisseur est sensiblement constante. Au niveau de la région renforcée 2.21, au moins une couche supplémentaire vient compléter l'empilement, elle confère à la région renforcée une épaisseur plus grande que celle du reste du film 20 de la membrane 2.

Sur la figure 6O, le film 20 de la membrane 2 est monocouche, il comporte une zone périphérique 2.4 à souplesse accrue dont l'épaisseur est moindre que celle du reste du film 20 de la membrane 2. L'épaisseur de la couche continue 20.1 est sensiblement constante et la même dans la zone d'ancrage 2.3, la zone intermédiaire 2.2 et la zone centrale 2.1.

Sur la figure 6P, le film 20 est multicouche dans la zone d'ancrage 2.3, la zone intermédiaire 2.2, la zone centrale 2.1, ces zones ayant sensiblement la même structure et la même épaisseur. Dans la zone périphérique à souplesse accrue 2.4, l'épaisseur du film 20 est moindre, il compte moins de couches que dans les autres zones. En l'occurrence dans l'exemple représenté il est monocouche dans cette zone périphérique à souplesse accrue 2.4.

Sur la figure 6Q, le film 20 est monocouche sensiblement d'une même épaisseur sensiblement constante dans la zone d'ancrage 2.3, dans la zone intermédiaire 2.2, dans la zone centrale 2.1. On prévoit une zone de renfort 2.5 qui est multicouche. Les pieds 5.12 des parties mobiles 5.1 des moyens d'actionnement électrostatiques 5 sont d'un seul tenant avec les régions de solidarisation 200 des pieds 5.12.

Toutes les structures présentées aux figures 6 peuvent être combinées pour former encore plus de variantes.

La zone centrale 2.1 peut ainsi être composée d'un seul matériau ou de plusieurs selon qu'elle est monocouche ou multicouche. Cette couche continue s'étend sur toute la surface du film 20 de la membrane 2. La limite élastique de la zone centrale 2.1 est suffisante pour garantir une déformation dans le domaine élastique et ainsi une réversibilité de la déformation, c'est-à-dire un retour à une position initiale une fois que les moyens d'actionnement électrostatiques ont fini d'agir. De nombreux matériaux présentent à la fois les propriétés optiques de transmission, par exemple dans le visible, et d'élasticité requises. On citera par exemple des matériaux organiques comme le polydiméthylsiloxane (PDMS), le polyméthacrylate de méthyle (PMMA) mais aussi le polyéthylène téréphtalate (PET), le polycarbonate (PC), le parylène, les résines époxydes, dont le module d'Young est compris entre quelques 100 MPa et quelques GPa.

D'autres matériaux peuvent convenir et entrer dans la composition du film 20. Il peut s'agir de matériaux métalliques tels que le titane, le nitrure de titane, l'aluminium, l'oxyde d'étain et d'indium (ITO). Des matériaux minéraux tels le dioxyde de silicium, le nitrure de silicium, le germanium peuvent également entrer dans la composition du film 20.

L'épaisseur du film 20 ou de chacune de ses couches peut être comprise entre environ 10 nanomètres et quelques dizaines de micromètres pour une membrane 2 dont le diamètre est de l'ordre de quelques millimètres.

Jusqu'à présent la membrane 2 a été représentée circulaire mais il est bien entendu quelle peut prendre la forme d'un quadrilatère comme illustré sur la figure 7A ou qu'elle peut être elliptique ou plus généralement oblongue comme illustré sur la figure 7B. Sur ces figures le support 1 prend la forme d'un quadrilatère mais ce n'est pas limitatif.

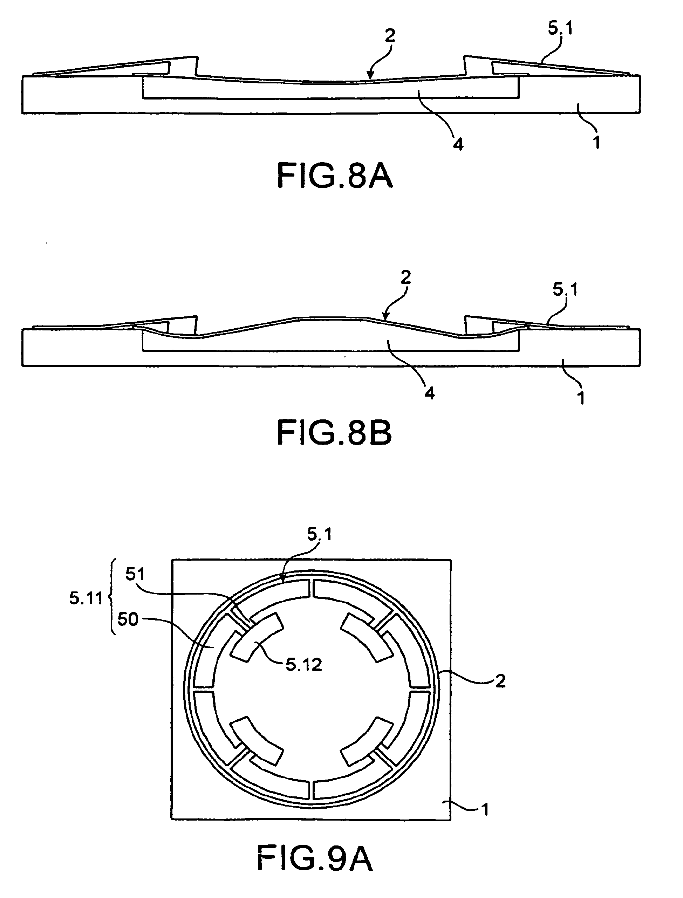

La membrane 2 a toujours été représentée convexe lorsque les moyens d'actionnement électrostatiques 5 sont au repos. Il est bien sûr possible que la membrane 2 soit concave alors que les moyens d'actionnement électrostatiques 5 sont au repos comme illustré sur la figure 8A. La figure 8B montre l'allure de la membrane 2 lorsque les moyens d'actionnement électrostatiques 5 sont en position de travail. Il est possible que la membrane 2 soit sensiblement plane lorsque les moyens d'actionnement électrostatiques sont au repos. On notera que pour bien maîtriser la forme du dioptre, que ce soit en position de repos des moyens d'actionnement électrostatiques 5 qu'en position de travail, il est préférable que le film 20 soit en tension lorsque les moyens d'actionnement électrostatiques 5 sont en position de repos.

La figure 9A représente une structure de membrane 2 dans laquelle deux jambes 5.11 coopèrent avec un seul pied 5.12. Pour augmenter la surface des jambes 5.11 sans augmenter la surface globale de la membrane 2, il est possible que les jambes 5.11 soient repliées, elles comportent au moins deux tronçons 50, 51 dirigés selon des directions différentes et raboutés. Dans l'exemple décrit on prévoit un premier tronçon 51 rectiligne radial et un second tronçon 50 sensiblement transversal au premier tronçon 51 et dans cet exemple en forme d'arc de cercle. Sur cet exemple, la partie mobile 5.1 est vue en transparence à travers le film 20 car elle est solidaire du film de la membrane 2 sur sa face en contact avec le liquide.

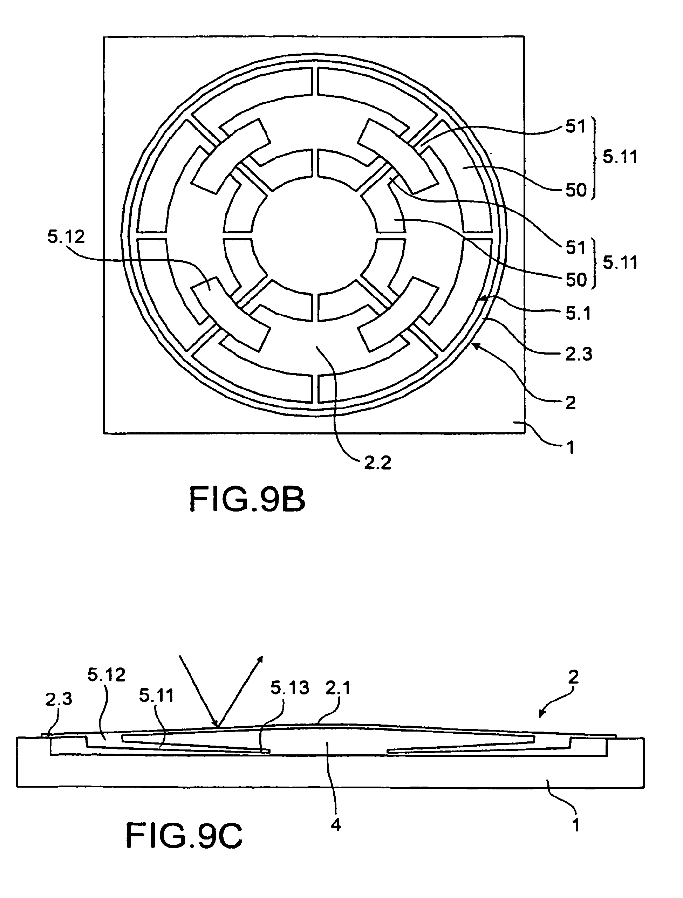

Sur la figure 9B, on a représenté une structure de membrane dans laquelle quatre jambes 5.11 coopèrent avec un seul pied 5.12. La géométrie des jambes est similaire à celle de la figure 9A. Pour deux des jambes 5.11, leur extrémité est située à l'opposé de la zone centrale 2.1 par rapport au pied 5.12, et pour deux autres leur extrémité est située du côté de la zone centrale 2.1 à l'opposé de la zone d'ancrage périphérique 2.3 par rapport au pied 5.12. Dans ce cas également, la partie mobile 5.1 est solidaire du film de la membrane 2 sur sa face en contact avec le liquide. Sur la figure 9C qui est une coupe, on voit les extrémités 5.13 des jambes 5.11 qui se trouvent dans le liquide 4, au niveau de la zone centrale 2.1 de la membrane 2. Les jambes 5.11 ainsi configurées ne dégradent pas les performances optiques du dispositif car celui-ci fonctionne en réflexion.

Dans un dispositif fonctionnant en transmission, les jambes peuvent s'étendre sur toute la surface de la membrane non utilisée optiquement. Dans un dispositif fonctionnant en transmission, elles peuvent s'étendre sous la zone intermédiaire et même sous la zone centrale à un endroit non utilisé optiquement. Dans un dispositif fonctionnant en réflexion, elles peuvent s'étendre sous toute la zone centrale.

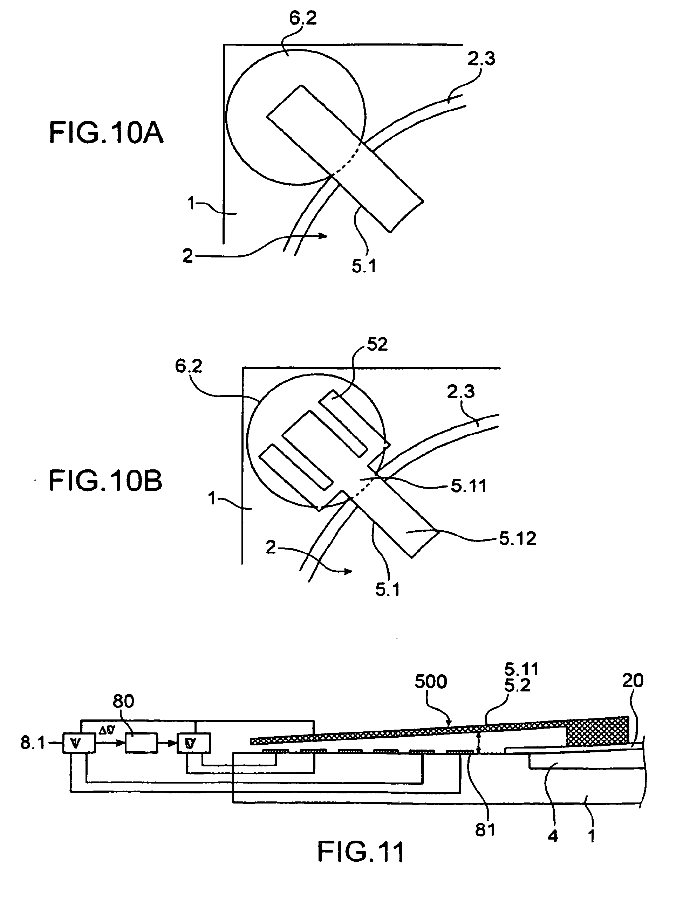

Afin de maximiser la force électrostatique qui s'exerce entre l'électrode mobile 5.2 de la partie mobile 5.1 et l'électrode fixe 6.2 portée par le support 1, on recherche que l'intersection entre les surfaces de l'électrode fixe 6.2 et de l'électrode mobile 5.2 soit la plus grande possible. Par contre il faut éviter que l'électrode mobile 5.2 soit trop rigide, sa souplesse est primordiale afin de permettre la déflection de la jambe 5.11 et l'optimisation de la force électrostatique. Afin de maximiser les surfaces en regard sans pour autant pénaliser la souplesse de la jambe 5.11 au niveau de son extrémité libre 5.12 il est possible de ramifier l'extrémité de la jambe 5.11 comme illustré sur la figure 10B. La jambe 5.11 se termine par plusieurs doigts 52, en l'occurrence trois. Le cercle matérialise la surface de l'électrode fixe 6.2 dédiée à l'électrode mobile 5.1. Sur la figure 10A on a représenté l'extrémité libre 5.13 de la jambe 5.11 sans ramification. On suppose que sur ces figures l'électrode mobile 5.2 occupe sur toute la surface de la jambe 5.11. Sur la figure 10B l'intersection entre les surfaces des deux électrodes fixe et mobile 5.2, 6.2 est beaucoup plus grande que sur la figure 10A.

Un autre avantage au fait de privilégier la souplesse de l'électrode mobile 5.2 est de pouvoir réduire l'espacement entre l'électrode mobile 5.2 et l'électrode fixe 6.2 en position de travail. A l'extrême, il peut y avoir un contact physique entre l'électrode mobile 5.2 et l'électrode fixe 6.2 via un matériau diélectrique 7 comme on l'a vu aux figures 4C, 4D.

Chaque électrode mobile 5.2 peut coopérer avec une électrode fixe 6.2 qui lui est dédiée comme on l'a représenté sur les figures 10A, 10B. En variante, on peut prévoir une unique électrode fixe 6.2 qui coopère avec toutes les électrodes mobiles 5.2 comme illustré sur la figure 3I.

Les parties mobiles 5.1 des moyens d'actionnement électrostatiques 5 peuvent être pilotées simultanément en parallèle ou au contraire de manière indépendante les unes des autres. Ce dernier mode de réalisation est intéressant notamment en optique adaptative ou pour des applications à focale variable dans lesquelles certains effets extérieurs, qui peuvent perturber la géométrie du dioptre comme l'effet de la pesanteur par exemple, sont à compenser.

Il se peut que des aberrations optiques apparaissent avec un dispositif optique ayant une telle membrane 2. Elles sont liées au manque de parallélisme entre le bord de la membrane 2 déformée et le support 1 au niveau de l'ancrage. Elles peuvent notamment apparaître lorsque le dispositif optique de l'invention est réalisé à partir de deux substrats assemblés comme il sera décrit par la suite. Elles se traduisent par une flèche maximum qui n'est plus au centre du champ optique 2.1. L'axe optique du dispositif optique passe par le centre du champ optique 2.1. La qualité des images est détériorée.

Pour limiter un tel phénomène dans les lentilles liquides conventionnelles, on cherchait à optimiser l'assemblage de la membrane 2 au support 1, cet assemblage était basé sur des techniques de scellement afin qu'au repos le parallélisme requis soit obtenu. Mais ensuite lorsque la lentille est en fonctionnement, on peut être amené à faire varier sa distance focale grâce à une tension d'alimentation V0 utilisée pour actionner les moyens d'actionnement électrostatiques 5. Si le déplacement induit par les moyens d'actionnement électrostatiques 5 n'est pas homogène sur toute la périphérie de la membrane 2, le phénomène apparaît et la qualité de l'image est dégradée. L'espace d entre le fond 3.1 de la cuvette 3 et la région de solidarisation 200 des pieds 5.12 des parties mobiles 5.1 n'est pas constant sur toute la périphérie de la membrane 2. Cette anomalie peut également se produire dans un dispositif optique selon l'invention si on ne fait rien lors de la commande des moyens d'actionnement électrostatiques 5. En effet, les différents actionneurs électrostatiques peuvent ne pas être alimentés avec exactement la même tension V0. Une dérive de la course de certaines parties mobiles 5.1 peut se produire. La pression du liquide 4 peut ne pas être totalement uniforme sur toute la périphérie de la membrane 2, cela peut se produire si le dispositif optique est employé légèrement incliné d'un côté. En fonctionnement, le phénomène est donc difficile à maîtriser et pénalise fortement ce type de dispositif optique. Afin de lutter contre cet effet, il est possible de prévoir un contrôle de la commande des moyens d'actionnement électrostatiques 5.

On se réfère à la figure 11. La variation de la distance focale du dispositif optique est toujours obtenue grâce à l'action des actionneurs 500 des moyens d'actionnement électrostatiques lorsqu'ils sont actionnés, par application d'une tension d'alimentation V0 entre électrode mobile 5.2 et électrode fixe 6.2 visant à générer une déformation mécanique des jambes 5.11.

On prévoit de plus des moyens d'asservissement 80 de la tension V0 à appliquer aux actionneurs 500 en fonction de l'espacement entre l'électrode mobile 5.2 et le support 1. Les moyens d'asservissement 80 coopèrent avec des moyens de mesure 8.1 capacitifs de l'espacement entre l'électrode mobile 5.2 et le support 1. Les moyens de mesure 8.1 peuvent comporter plusieurs couples d'électrodes 5.2, 81 répartis entre le support 1 et la jambe 5.11 qui est confondue avec l'électrode mobile. En appliquant une différence de potentiel V1 sur les deux électrodes 5.2, 81 de chaque couple d'électrodes et en mesurant la capacité sur chaque couple d'électrodes 5.2, 81, on acquiert au niveau de chacun des couples d'électrodes 5.2, 81 la distance qui les sépare. L'une des électrodes est confondue avec l'électrode mobile d'un actionneur électrostatique 500 et l'autre électrode est disposée sur le support 1.

Sur la figure 11, on n'a fait que schématiser les moyens d'asservissement 80, on ne les voit que pour un couple d'électrodes 5.2, 81 et un actionneur 500. L'électrode 81 située sur le support 1 d'un couple d'électrodes de mesure capacitive peut être une électrode supplémentaire ne servant qu'à la mesure ou peut être une électrode fixe des moyens d'actionnement électrostatiques. La même remarque s'applique pour l'électrode mobile portée par la jambe, elle pourrait être une électrode supplémentaire. Dans le cas où les électrodes de la paire ne sont pas dédiées uniquement à la mesure capacitive, on peut les utiliser alternativement pour l'actionnement et pour la mesure. On peut disposer sur le support 1 plusieurs électrodes fixes 6.2 réparties de manière concentrique comme illustré sur la figure 11. En variante, les moyens de mesure pourraient être situés entre le fond de la cuvette et le film de la membrane.

Lors du fonctionnement du dispositif optique objet de l'invention, on réalise une ou plusieurs mesures capacitives au niveau d'au moins un actionneur 500, les moyens d'asservissement 80 reçoivent les mesures capacitives des moyens de mesure 8.1, les comparent à une valeur de référence et si les résultats de la comparaison ne sont pas ceux attendus commandent qu'une tension supplémentaire de correction ΔV0, en plus de la tension de référence V0, soit appliquée à l'actionneur 500 correspondant, aux endroits où la mesure capacitive diffère de la valeur de référence.

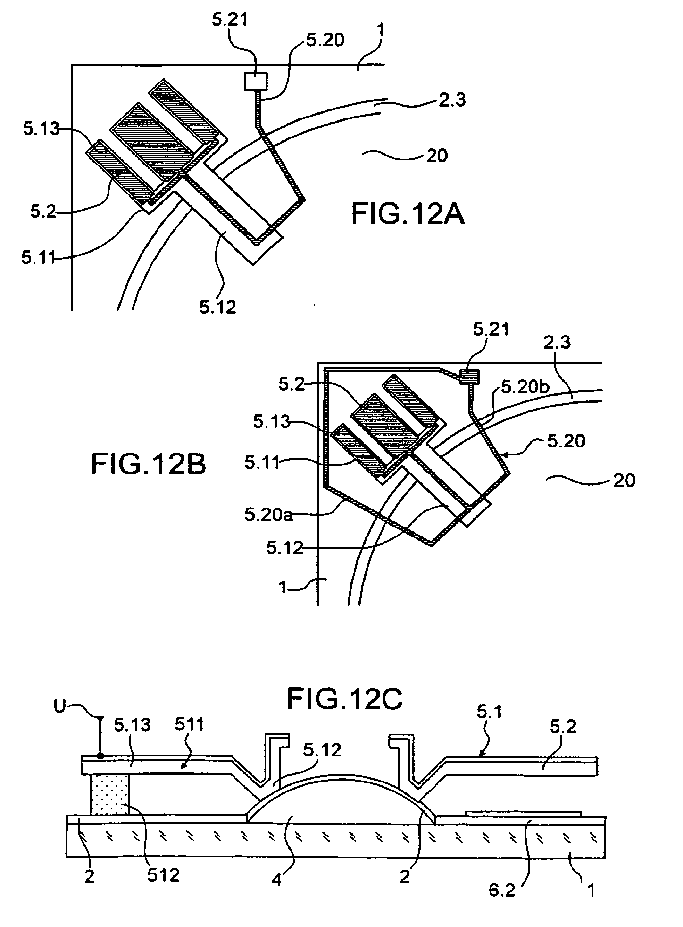

On va maintenant ajouter des détails sur la partie mobile 5.1 des actionneurs électrostatiques 500 et se référer aux figures 12A à 12F. Sur la figure 12A, on montre une vue de dessus de la partie mobile 5.1 avec la jambe 5.11 dont l'extrémité libre 5.13 est ramifiée. La jambe 5.11 est raccordée au pied 5.12 qui est solidarisé au film 20 de la membrane 2. Le pied 5.12 correspond sensiblement à partie incluse dans le cercle en pointillés. Dans cet exemple la jambe 5.11 et le pied 5.12 sont réalisés dans un matériau diélectrique. La partie hachurée représente l'électrode mobile 5.2 qui est sus jacente à la jambe 5.11 et qui se prolonge par un tronçon de piste conductrice 5.20 jusqu'à un plot de contact 5.21 pour l'alimentation en énergie situé sur le support 1.

Il est bien sûr possible que la jambe 5.11 et/ou le pied 5.12 soient réalisés dans un matériau conducteur. Dans ce cas la jambe 5.11 forme l'électrode mobile et le pied 5.12 contribue à former la liaison électrique vers le plot de contact 5.21. Il se peut que la piste conductrice 5.20 qui court de l'électrode mobile 5.2 au plot de contact 5.21 soit réalisée dans le même matériau que l'électrode mobile 5.2 comme illustré sur la figure 12A ou dans un matériau différent si la jambe 5.11 et le pied 5.12 sont l'un conducteur et l'autre diélectrique par exemple.

Pour résumer, la partie mobile des moyens d'actionnement électrostatiques peut être réalisée à base de matériaux organiques choisis parmi le polydiméthylsiloxane (PDMS), le polyméthacrylate de méthyle (PMMA) le polyéthylène téréphtalate (PET), le polycarbonate (PC), le parylène, les résines époxydes, de matériaux minéraux choisis parmi le dioxyde de silicium, le nitrure de silicium, le germanium, de matériaux métalliques choisis parmi le titane, le nitrure de titane, l'aluminium, l'oxyde d'étain et d'indium (ITO), l'or, le chrome.

Sur la figure 12A, la piste conductrice 5.20 court sur le film 20 de la membrane 2, et atteint le support 1 au-delà de la membrane 2. Afin de symétriser l'effet mécanique de la piste conductrice 5.20 sur le film 20 de la membrane 2 et sur le pied 5.12, il est possible de dédoubler la piste conductrice 5.20 en deux brins 5.20a, 5.20b de manière à la rendre symétrique par rapport au tronçon courant sur le pied 5.12. Sur la figure 12B, les deux brins 5.20a, 5.20b de la piste conductrice 5.20 se rejoignent au niveau du plot de contact 5.21 et forment une boucle fermée. La reprise de contact entre la piste conductrice 5.20 et l'électrode mobile 5.2 peut se faire directement comme illustré sur les figures 12A, 12B. Cela pourrait être le cas également si la jambe 5.11 était conductrice. Par contre si l'électrode mobile 5.2 est sous jacente à la jambe 5.11 ou est insérée entre deux couches diélectriques 7 de la jambe 5.11 comme illustré à la figure 4C, la reprise de contact entre la piste conductrice 5.20 et l'électrode mobile 5.2 se fait par l'intermédiaire d'un trou métallisé 60.

Dans la mesure où les jambes 5.11 partagent un pied unique 5.12 continu en forme de couronne, comme illustré à la figure 3B, il est possible d'utiliser au moins une jambe sacrifiée 511 dédiée à l'alimentation électrique des électrodes mobiles 5.2. Cette jambe sacrifiée 511 a une extrémité qui au lieu d'être libre est fixée mécaniquement au support 1, dans l'exemple par l'intermédiaire d'une cale 512. La jambe sacrifiée 511 est reliée électriquement à une source d'énergie U. Cette jambe sacrifiée 511 permet d'alimenter les électrodes mobiles 5.2 par l'intermédiaire du pied unique 5.12.

Dans ce cas la jambe sacrifiée 511 ne participe pas à l'actionnement et, dans ce sens n'exerce pas de force sur le film 20 de la membrane 2. Pour garder une symétrie de déformation il est possible de sacrifier plusieurs jambes et de les dédier à l'alimentation électrique. D'autres solutions sont possibles pour l'alimentation en énergie.

Il est possible d'utiliser le pied pour ramener une reprise de contact au niveau du support et prévoir une opération de soudure d'un fil d'alimentation sur le support dans une zone éloignée de la membrane.

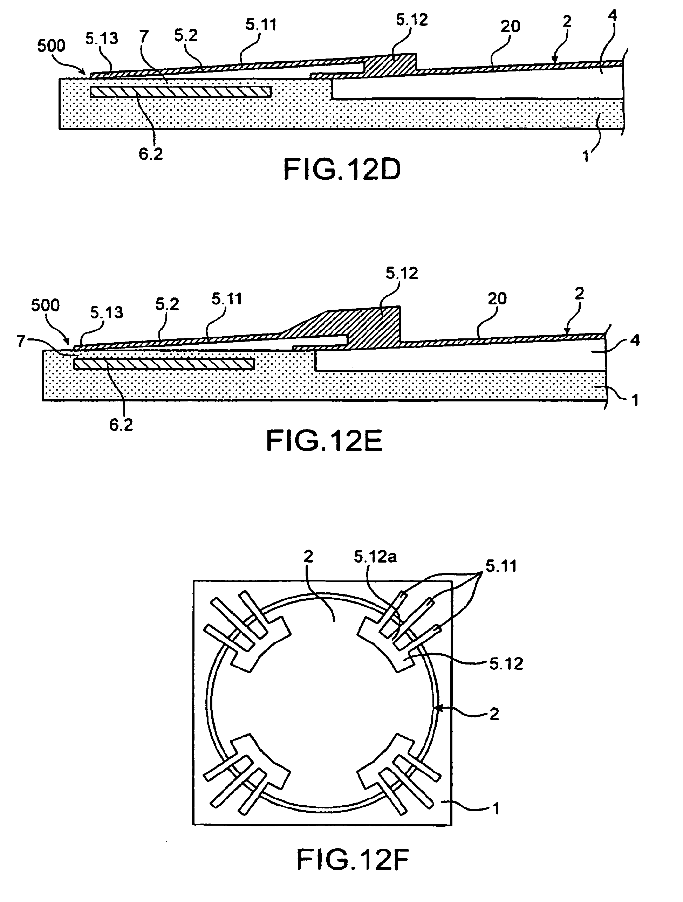

Sur la figure 12C, seule la jambe 511 de gauche est sacrifiée, celle de droite est opérationnelle. La géométrie, la rigidité et la position des jambes sacrifiées 511 devront être optimisées pour limiter l'impact de ces jambes sacrifiées 511 sur la déformation du film 20 de la membrane 2. Le pied 5.12 de la partie mobile 5.2 solidarisé au film 20 de la membrane 2 permet de transmettre l'effort généré par l'actionnement électrostatique sur la membrane 2 pour déplacer le liquide 4. Afin d'optimiser le transfert d'efforts et de déplacement, la structure du pied 5.12 peut être déterminée par simulation à l'aide d'un logiciel de simulation mécanique comme ANSYS par exemple. Généralement on cherche à accroître la rigidité du pied 5.12 comme illustré sur la figure 12E. Sur la figure 12D, le pied 5.12 est moins massif, moins épais, moins rigide que sur la figure 12E.

Sur la figure 12F, on a représenté un pied 5.12 qui comporte une portion ramifiée 5.12a, chacune des ramifications se poursuit par une jambe 5.11. Le pied 5.12 est commun à plusieurs jambes 5.11.

Concernant le matériau du pied 5.12, il peut être le même que celui de la jambe 5.11 ou être différent. Des matériaux qui conviennent pour ces deux parties, pied 5.12 et jambe 5.11 ont déjà été énumérés plus haut, à savoir des matériaux conducteurs métalliques tels que le nitrure de titane, l'or, un empilement chrome/or, l'aluminium, dans ce cas ils constituent l'électrode mobile 5.2. Si l'électrode mobile 5.2 est portée par la jambe 5.11 et qu'une piste conductrice 5.20 court sur le pied 5.12, ils peuvent être réalisés dans un matériau diélectrique tel que le nitrure de silicium ou le dioxyde de silicium par exemple. L'épaisseur du pied 5.12 peut être comprise entre environ quelques nanomètres et quelques dizaines de micromètres.

Le nombre d'actionneurs électrostatiques 500 et donc le nombre de parties mobiles 5.1 ancrées sur le film 20 de la membrane 2 peut être quelconque.

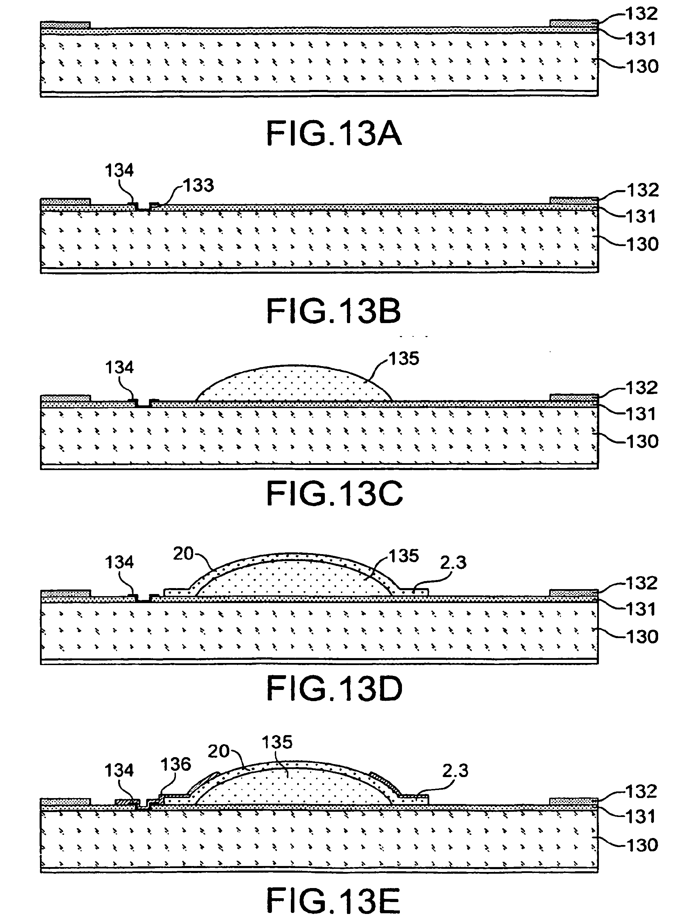

On va maintenant décrire en se référant aux figures 13A à 13O un exemple de procédé de réalisation d'un dispositif optique à membrane déformable dans lequel la partie mobile des moyens d'actionnement électrostatiques est située en contact avec le liquide. On part sur la figure 13A d'un substrat initial 130 semi-conducteur en silicium par exemple. On réalise en surface une couche diélectrique 131, par exemple de l'oxyde thermique. On prévoit sur ce substrat initial 130 sera collé à un dispositif de protection qui peut prendre la forme d'un second substrat et optionnellement on peut préparer la zone de collage en déposant un matériau 132 présentant de bonnes propriétés d'adhérence vis-à-vis de la technologie de collage choisie. La colle sera mise en place ultérieurement après la création des électrodes fixes

A la figure 13B, par une opération de gravure après lithographie, on ouvre au moins une ouverture 133 dans la couche diélectrique 131 devant accueillir un plot de contact 134 pour les électrodes mobiles à venir. On forme le plot de contact 134 dans l'ouverture 133 par exemple par dépôt physique en phase vapeur (PVD) d'une couche métallique et gravure après lithographie. Le dépôt peut être un empilement titane/nickel/or par exemple.

A la figure 13C, on forme une couche sacrificielle et on lui fait prendre une forme appropriée par exemple bombée de manière à ce qu'elle puisse servir de premier moule sacrificiel 135 celui servant pour le film 20 de la membrane 2. La couche sacrificielle peut être réalisée en polymère photosensible. La mise en forme du premier moule sacrificiel 135 peut être réalisée par lithographie et fluage à chaud.

On dépose, à la figure 13D, le film 20 de la membrane 2 sur le premier moule sacrificiel 135 et on le délimite de manière à ce qu'il recouvre le premier moule sacrificiel 135 et déborde tout autour sur le substrat recouvert. Ce qui déborde correspond à la zone d'ancrage 2.3. La délimitation peut se faire par gravure après lithographie. Le film 20 peut être du nitrure de silicium et il peut être déposé par PECVD (dépôt chimique en phase vapeur assisté par plasma).

On réalise à la figure 13E au moins une piste conductrice 136 devant conduire à une ou plusieurs électrodes mobiles. Elle surmonte le plot de contact 134 et court sur le film 20 de la membrane sur sa zone d'ancrage 2.3 et sa zone intermédiaire au niveau des régions de fixation. Pour la réaliser, on peut déposer deux couches métalliques par PVD de type chrome/or par exemple et les délimiter par gravure après lithographie.

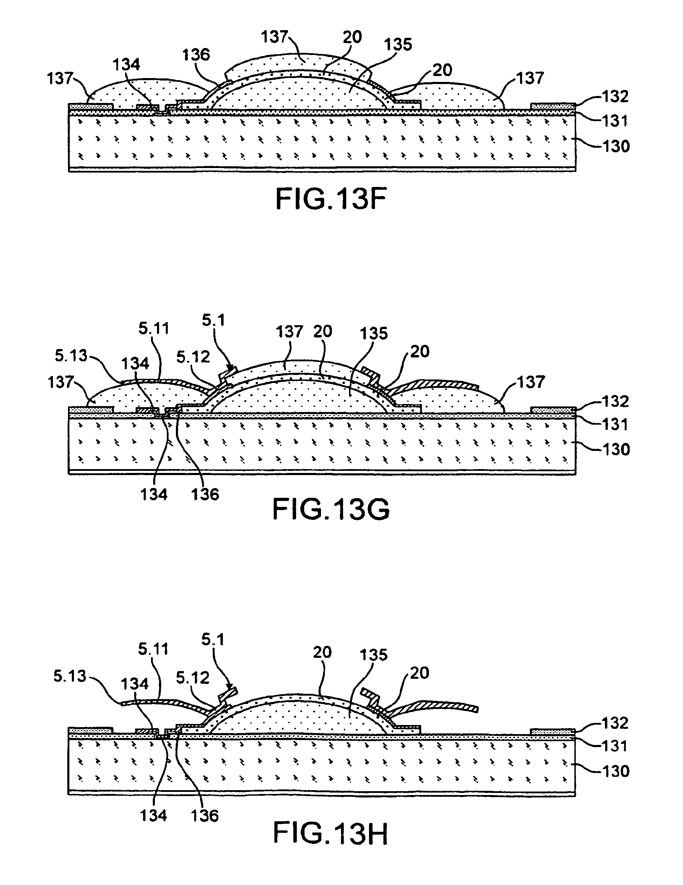

On dépose une couche sacrificielle que l'on met en forme. Elle doit servir de second moule sacrificiel 137 à la partie mobile de chaque actionneur électrostatique. Ce second moule sacrificiel 137 peut se faire de la manière que celui servant pour le film 20 de la membrane 2. La couche sacrificielle peut être réalisée en polymère photosensible. La mise en forme peut être réalisée par lithographie et fluage à chaud. Le second moule sacrificiel 137 peut recouvrir optionnellement le film de la membrane 2 dans sa zone centrale 2.1 notamment pour la protéger mais elle laisse à nu localement la piste 136 créée précédemment dans sa partie au niveau de la zone intermédiaire pour accueillir le pied de la partie mobile. On se réfère à la figure 13F.

On réalise ensuite la partie mobile 5.1 de chaque actionneur électrostatique avec son pied 5.12 solidarisé au film 20 de la membrane 2 surmontant la piste 136 créée précédemment et avec sa jambe 5.11 ayant une extrémité libre 5.13 et l'autre reliée au pied 5.12 (figure 13G). On libère ensuite la partie mobile 5.1 en éliminant le second moule sacrificiel 137 par plasma d'oxygène et éventuellement en réalisant une opération de nettoyage (figure 13H).

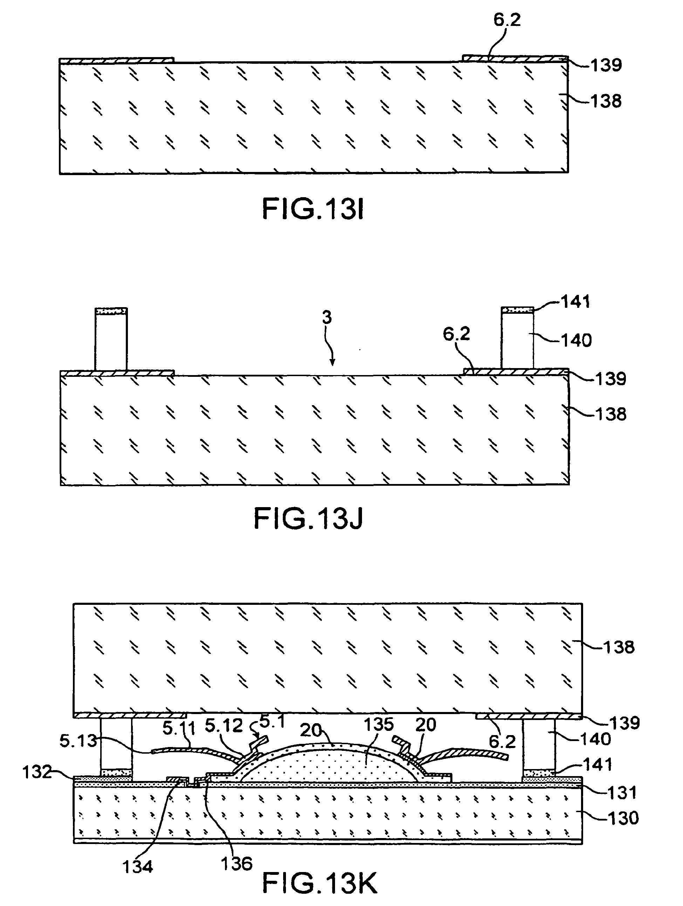

Sur un second substrat transparent 138 à la lumière avec laquelle doit fonctionner le dispositif optique, par exemple en verre, on va déposer une couche métallique destinée à réaliser au moins une électrode fixe 6.2 de chaque actionneur électrostatique reliée à au moins un plot de contact approprié 139. On délimite ensuite le contour de chaque électrode 6.2 et du plot de contact 139 par gravure après lithographie. Cette électrode fixe 6.2 peut être réalisée par exemple avec un empilement chrome/or. On se réfère à la figure 13I.

On va bâtir à la figure 13J au dessus de l'électrode fixe 6.2 des parois latérales 140 de la cuvette 3 devant accueillir le liquide emprisonné par la membrane. Le plot de contact 139 est laissé à l'extérieur de la cuvette 3. Les parois latérales 140 de la cuvette 3 peuvent être formées par dépôt d'une couche de dioxyde de silicium par exemple par PECVD puis gravure après lithographie. Le sommet des parois 140 peut être optionnellement traité en vue d'un collage par exemple en en déposant un matériau présentant de bonnes propriétés d'adhérence vis-à-vis de la technologie de collage choisie. On dépose ensuite de la colle 141.

L'étape suivante illustrée à la figure 13K consiste à assembler les deux substrats 138 et 130 de manière à ce que la partie mobile 5.1 des actionneurs soient située dans la cuvette 3. Le second substrat 138 sert de protection.

Il est possible d'amincir le substrat initial 130 par rodage de sa face arrière, cette étape étant illustrée à la figure 13L. On peut également prévoir à ce stade le dépôt d'au moins un plot de contact extérieur 142 à la cavité 3 qui devra être relié par un trou métallisé au plot de contact 134 réalisé sur l'autre face du substrat initial 130 et donc à l'intérieur de la cavité 3.

A la figure 13M, par une opération de gravure après lithographie, on va réaliser au moins un trou 143 traversant dans le substrat initial 130 débouchant dans la cavité 3 pour son remplissage, un trou 144 débouchant au niveau du plot de contact 134 et un trou traversant 145 plus grand au niveau de la membrane 2 délimitant dans le substrat initial 130 un cadre sur lequel est ancré le film 20. Grâce à cet accès 145 on peut libérer la membrane 2 en éliminant le matériau sacrificiel du premier moule sacrificiel 135. Dans une variante, on aurait pu envisager de réaliser un accès au travers du film de la membrane pour éliminer le premier moule sacrificiel 135. La gravure peut être une gravure ionique réactive RIE. Le trou 146 dans le substrat initial servant à éliminer le premier moule sacrificiel 135 aura de préférence au moins la taille de la zone centrale du film. L'élimination peut se faire avec un plasma d'oxygène.

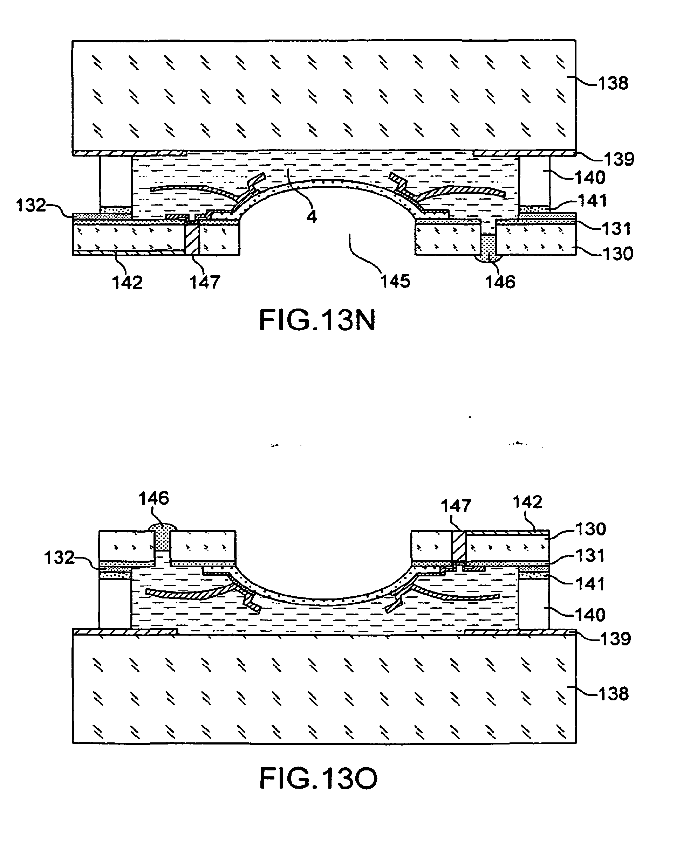

A la figure 13N, on remplit la cavité 3 de liquide 4, on bouche le trou 143 d'accès à la cavité 3 avec un bouchon 146 en colle organique ou en alliage métallique et on remplit le trou traversant 144 avec un matériau métallique par exemple un empilement chrome/or, de manière à assurer une continuité électrique entre le plot de contact 134 intérieur à la cavité et le plot de contact 142 extérieur à la cavité. On obtient alors un trou métallisé référencé 147 sur la figure 13N. Si le silicium est un silicium à faible résistivité par exemple de l'ordre de 10 micro ohms par centimètre, il n'est plus nécessaire de prévoir de trou métallisé, le substrat lui-même assure une continuité électrique entre le plot de contact interne 134 et le plot de contact externe 142. Les électrodes mobiles 5.2 sont alors toutes au même potentiel. L'utilisation de trous métallisés permet de différencier les potentiels des électrodes mobiles.

Puisqu'un tel procédé permet de réaliser de manière collective plusieurs dispositifs optiques sur les substrats, on découpe à la figure 13O, séparément, le substrat initial 130 et le second substrat 138 de manière à individualiser les différents dispositifs optiques. On a schématisé des scies S pour effectuer les découpes. Les traits de scie séparent électriquement les plots de contacts 139, 142 qu'ils soient reliés aux électrodes fixes ou aux électrodes mobiles. La découpe se fait en deux temps car une fois découpé le second substrat 138 est plus grand que le substrat initial 130. Cette différence de taille permet d'accéder aisément au plot de contact 139.

On va maintenant décrire en se référant aux figures 14A à 14M un exemple de procédé d'un dispositif optique selon l'invention dans lequel la partie mobile des moyens d'actionnement de la membrane se trouve à l'opposé du liquide lorsque le dispositif optique est monté.

On part d'un substrat initial 150 en silicium par exemple dont l'une des faces principales est recouverte d'une couche diélectrique 151, du dioxyde de silicium par exemple. Dans cet exemple, le substrat initial 150 est plan mais on aurait pu utiliser un substrat doté d'une cuvette, gravée par exemple par voie sèche de type gravure ionique réactive (RIE) ou par voie humide à l'aide de potasse KOH pour un substrat en silicium. Après la création de la cuvette, le substrat ainsi structuré peut être recouvert d'oxyde thermique par exemple.

On dépose à la figure 14A sur la couche diélectrique 151, une couche métallique par exemple dans un empilement de sous couches chrome/or que l'on délimite par gravure après lithographie pour réaliser au moins une électrode fixe 6.2 se terminant par un plot de contact 159.

A la figure 14B, on forme une couche sacrificielle et on lui fait prendre une forme appropriée par exemple bombée de manière à ce qu'elle puisse servir de premier moule sacrificiel 155 pour le film 20 de la membrane 2. La couche sacrificielle peut être réalisée en polymère photosensible. La mise en forme du premier moule sacrificiel 155 peut être réalisée par lithographie et fluage à chaud.

A la figure 14C, on dépose le film 20 de la membrane 2 sur le premier moule sacrificiel 155 et on le délimite de manière à ce qu'il recouvre le premier moule sacrificiel 155 et déborde tout autour jusqu'à l'électrode fixe 6.2 et au plot de contact 159. Ce qui déborde correspond à la zone d'ancrage 2.3. La délimitation peut se faire par gravure après lithographie. Le film 20 peut être du nitrure de silicium et il peut être déposé par PECVD (dépôt chimique en phase vapeur assisté par plasma).

On réalise à la figure 14D au moins une piste conductrice 156 devant conduire à au moins une électrode mobile à venir. Elle court sur la membrane 2 sur sa zone d'ancrage 2.3 et sa zone intermédiaire 2.2 au niveau des régions de fixation. Elle s'arrête avant de surmonter l'électrode fixe 6.2 par un plot de contact 154. Pour les réaliser, on peut déposer une couche métallique par PVD d'un empilement chrome/or par exemple et la délimiter par gravure après lithographie.

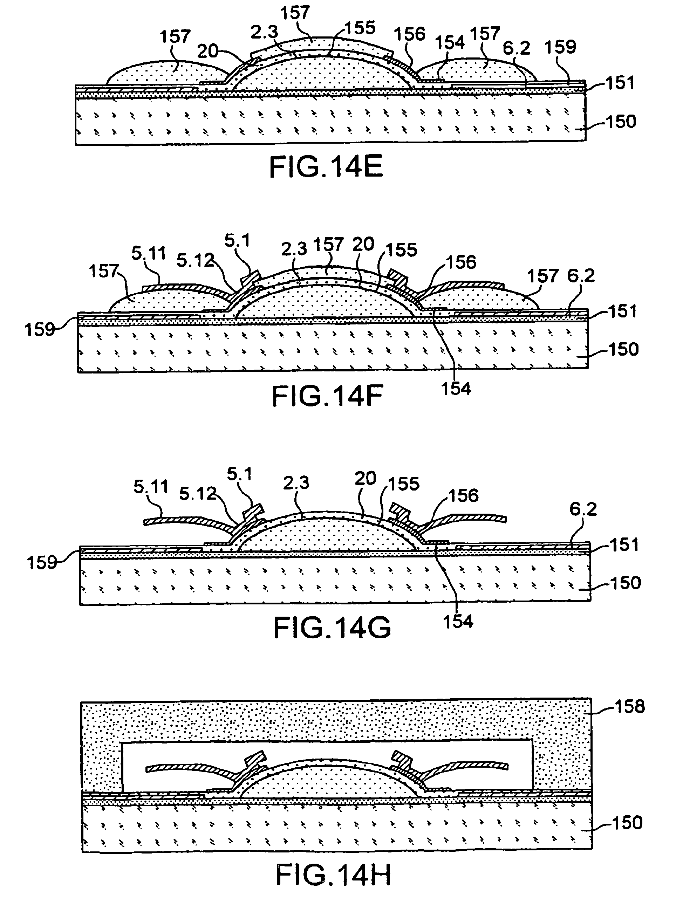

On dépose une couche sacrificielle que l'on met en forme devant servir de second moule sacrificiel 157 pour la partie mobile de chaque actionneur électrostatique. Ce second moule sacrificiel 157 peut se faire de la manière que celui servant pour la membrane 2. La couche sacrificielle peut être réalisée en polymère photosensible. La mise en forme peut être réalisée par lithographie et fluage à chaud. La couche sacrificielle peut recouvrir optionnellement la membrane 2 dans sa zone centrale 2.1 notamment pour la protéger mais elle laisse à nu localement la piste conductrice 156 créée précédemment dans sa partie au niveau de la zone intermédiaire 2.2 pour accueillir le pied de la partie mobile. On se réfère à la figure 14E.

On réalise ensuite la partie mobile 5.1 de chaque actionneur électrostatique avec son pied 5.12 solidarisé au film 20 de la membrane 2 surmontant la piste 156 créée précédemment dans sa partie au niveau de la zone intermédiaire 2.2, sa jambe 5.11 ayant une extrémité libre 5.13 et l'autre reliée au pied 5.12 (figure 14F). Cela peut se faire par exemple en déposant une couche d'un empilement chrome/or sur le second moule sacrificiel 157 et sur la piste conductrice 156 à l'endroit où elle est à nu pour la fixation du pied 5.12. On libère ensuite la partie mobile 5.1 en éliminant le second moule sacrificiel 157 par plasma d'oxygène et éventuellement en réalisant une opération de nettoyage (figure 14G).

On peut recouvrir la membrane 2 ainsi réalisée d'un dispositif de protection 158 tel un capot transparent en verre par exemple (figure 14H) par collage.

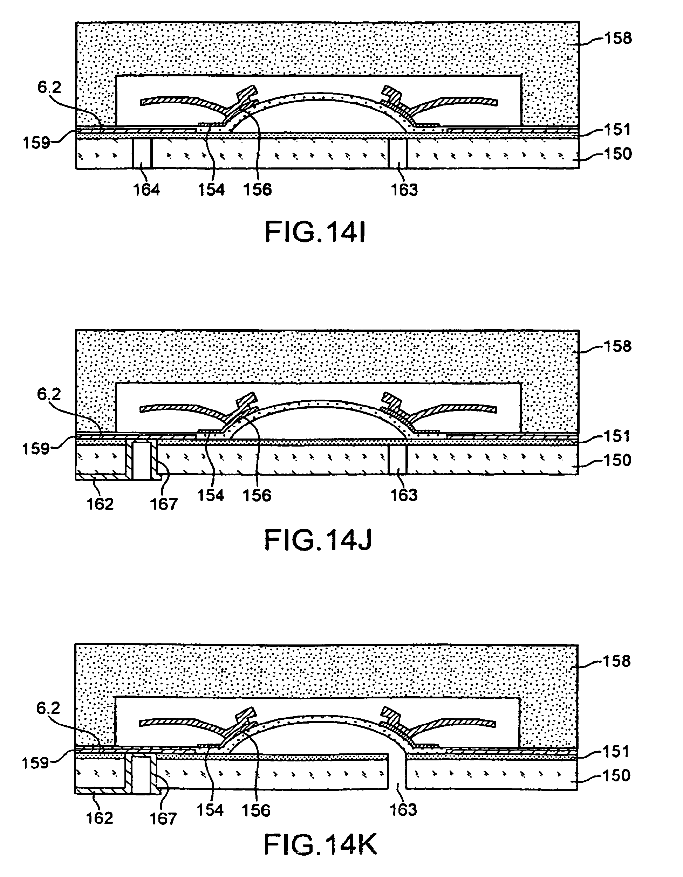

Il est possible d'amincir le substrat initial 150 par rodage de sa face arrière, cette étape étant illustrée à la figure 14I.

A la figure 14I, par une opération de gravure après lithographie, on va réaliser au moins un trou traversant 163 dans le substrat initial 150 débouchant sous la membrane 2 au niveau du premier moule sacrificiel 155 pour l'élimination du premier moule sacrificiel 155 et le remplissage du liquide, un trou débouchant 164 au niveau du plot de contact 159 relié à l'électrode fixe 6.2 et un trou débouchant au niveau du plot de contact 154 relié à la piste conductrice 156 devant alimenter en énergie la partie mobile 5.1. La gravure peut être une gravure ionique réactive (RIE) par exemple. Sur les figures 14I et suivantes on n'a représenté que le trou 164 relié à l'électrode fixe 6.2. L'autre n'est pas visible car située hors du plan de coupe des figures.

Les trous 164 débouchant au niveau des plots de contact sont ensuite métallisés à la figure 14J. Pour les mêmes raisons que celles indiquées plus haut, on ne voit qu'un seul trou métallisé et il porte la référence 167. On réalise également au moins un plot de contact 162 externe en continuité électrique avec chacun des trous métallisés 167.

A la figure 14K, on élimine le premier moule sacrificiel 155 par le trou 163 qui vient d'être gravé et l'on forme ainsi une cavité 3 sous le film 20 de la membrane 2.

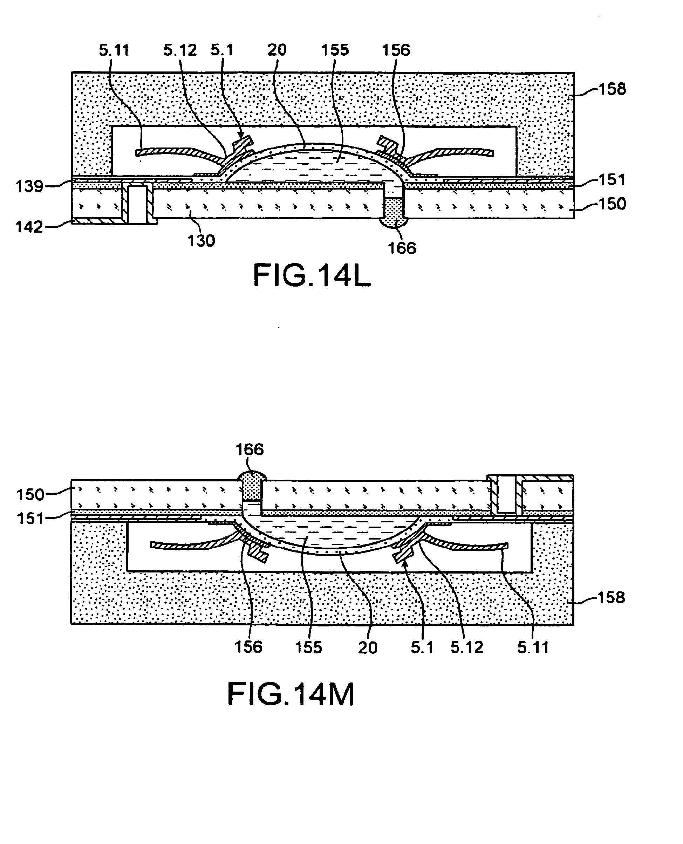

A la figure 14L, on remplit la cavité 3 de liquide 4 par le trou 163 et on le bouche à l'aide d'un bouchon 166.

On suppose que l'on a réalisé de manière collective plusieurs dispositifs optiques sur le substrat initial 150. On découpe à la figure 14M le substrat 150 de manière à individualiser les différents dispositifs optiques. On suppose que les capots 158 sont eux déjà individualisés.

Dans les exemples que l'on vient de décrire, on a supposé que les couches sacrificielles sont en polymère photosensible.

Il est bien sûr possible d'utiliser d'autres matériaux tels que le dioxyde de silicium déposé par PECVD, la libération se ferait par attaque chimique à l'aide d'acide fluorhydrique en phase vapeur ou liquide. Un autre exemple serait d'utiliser du silicium polycristallin déposé par PVD. La libération pourrait alors se faire avec un mélange gazeux de difluorure de xénon. Encore un autre exemple serait d'utiliser du tungstène déposé par PVD. La libération pourrait se faire par attaque chimique humide.

En ce qui concerne le collage du substrat initial et du dispositif de protection, de nombreuses techniques peuvent être employées notamment celles employées dans le domaine des MEMS (systèmes micro-électro-mécaniques) telles que le collage organique, le collage anodique, le collage eutectique or/silicium ou or/étain.

Les parois 140 de la cuvette 3 peuvent être réalisées autrement qu'en dioxyde de silicium. On peut par exemple utiliser un polymère photosensible négatif de type BCB (benzocyclobutène) délimité par lithographie.

Selon la technique de collage, la méthode pour réaliser la cuvette 3, le premier moule sacrificiel pour le film 20 ou les parties mobiles peuvent être différentes. Les exemples présentés ne sont pas limitatifs.

Bien que plusieurs modes de réalisation de la présente invention aient été décrits de façon détaillée, on comprendra que différents changements et modifications puissent être apportés sans sortir du cadre de l'invention et notamment bien d'autres procédés peuvent être utilisés pour réaliser la membrane et les moyens d'actionnement électrostatiques.

## Revendications

1. Dispositif optique comprenant une membrane (2) déformable de manière réversible comportant un film (20) souple possédant au moins une zone d'ancrage (2.3) périphérique, une zone centrale (2.1), une zone intermédiaire (2.2) entre la zone centrale (2.1) et la zone d'ancrage (2.3) périphérique, la membrane étant ancrée au niveau de sa zone d'ancrage (2.3) sur un support (1) et des moyens d'actionnement électrostatiques (5) avec une ou plusieurs électrodes fixes (6.2) portées par le support et une ou plusieurs parties mobiles (5.1), **caractérisé en ce que** le support et la membrane contribuent à emprisonner un volume constant de liquide (4) en contact avec l'une des faces du film (20), les parties mobiles des moyens d'actionnement étant formées chacune d'une jambe (5.11) se terminant d'un côté par un pied (5.12) solidaire mécaniquement d'une région de solidarisation (200) du film située dans la zone intermédiaire (2.2) et de l'autre par une extrémité libre non solidaire mécaniquement d'une région de solidarisation du dit film (20) (5.13), la jambe (5.11) intégrant une électrode mobile (5.2) au moins du côté de son extrémité libre, l'actionnement des moyens d'actionnement électrostatiques (5) d'une position de repos à une position de travail ayant pour effet d'attirer l'électrode mobile (5.2) vers l'électrode fixe (6.2) qui est placée en regard et de déplacer le liquide (4) se trouvant au niveau de la région de solidarisation (200) vers la zone centrale (2.1) de manière à ajuster le rayon de courbure de la membrane.

2. Dispositif optique selon la revendication 1, dans lequel le film (20) comporte au moins une couche continue (20.1) qui s'étend sur toute sa surface.

3. Dispositif optique selon l'une des revendications précédentes, dans lequel le pied (5.12) est fixé au film (20) ou fait partie intégrante du film (20).

4. Dispositif optique selon l'une des revendications précédentes, dans lequel la jambe (5.11) est ramifiée du côté de son extrémité libre.

5. Dispositif optique selon l'une des revendications précédentes, dans lequel le pied (5.12) possède des ramifications, une jambe (5.11) partant de chaque ramification.

6. Dispositif optique selon l'une des revendications précédentes, dans lequel un pied (5.12) coopère avec plusieurs jambes (5.11).

7. Dispositif optique selon l'une des revendications précédentes, dans lequel les parties mobiles (5.1) partagent un unique pied (5.12).

8. Dispositif optique selon l'une des revendications précédentes, dans lequel la jambe (5.11) est confondue avec l'électrode mobile (5.2).

9. Dispositif optique selon l'une des revendications 1 à 7, dans lequel l'électrode mobile (5.2) est un des constituants de la jambe (5.11).

10. Dispositif optique selon l'une des revendications précédentes, dans lequel la membrane (2) comporte en outre une piste conductrice (5.20) reliée à l'électrode mobile (5.2) qui court sur le film (20).

11. Dispositif optique selon la revendication 10, dans lequel la piste conductrice (5.20) se divise sur le film (20) en deux brins (5.20a, 5.20b) sensiblement symétriques par rapport à la jambe (5.11).

12. Dispositif optique selon l'une des revendications 3 à 11, dans lequel le film (20) comporte au niveau de la zone intermédiaire (2.2) une région renforcée (2.21) au niveau de laquelle le pied (5.12) est solidarisé au film (20).

13. Dispositif optique selon l'une des revendications précédentes, dans lequel le film (20) comporte une zone à souplesse accrue (2.4) entre la zone d'ancrage (2.3) et la zone intermédiaire (2.2).

14. Dispositif optique selon l'une des revendications précédentes, dans lequel le film (20) comporte une zone de renfort (2.5) entre la zone centrale (2.1) et la zone intermédiaire (2.2).

15. Dispositif optique selon l'une des revendications précédentes, dans lequel la jambe (5.11) comporte plusieurs tronçons (50, 51) raboutés, s'étendant dans des directions différentes.

16. Dispositif optique selon l'une des revendications précédentes, dans lequel l'extrémité libre (5.13) dépasse du bord du film (20).

17. Dispositif optique selon l'une des revendications précédentes, dans lequel l'électrode fixe (6.2) coopère avec une ou plusieurs électrodes mobiles (5.2).

18. Dispositif optique selon l'une des revendications précédentes, comportant en outre au moins une jambe sacrifiée (511) fixe dont l'extrémité (5.13) est solidaire du support (1), cette jambe sacrifiée (511) fixe étant destinée à être reliée à une source d'énergie (U) et à alimenter par le pied (5.12) auquel elle est reliée au moins une électrode mobile (5.2) d'une partie mobile (5.1).

## Claims

1. Optical device comprising a membrane (2) deformable in a reversible manner comprising a flexible film (20) having at least one peripheral anchoring zone (2.3), a central zone (2.1), an intermediate zone (2.2) between the central zone (2,1) and the peripheral anchoring zone (2.3), the membrane being anchored at the level of its anchoring zone (2.3) on a support (1) and electrostatic actuating means (5) with one or more fixed electrodes (6.2) borne by the support and one or more movable parts (5.1), **characterised in that** the support and the membrane contribute to trapping a constant volume of liquid (4) in contact with one of the faces of the film (20), the movable parts of the actuating means each being formed of a leg (5.11) terminating on one side in a foot (5.12) mechanically fastened to a film-fastening region (200) located in the intermediate zone (2.2) and terminating on the other side in a free end (5.13), non mechanically fastened to a fastening region of said film (20), the leg (5.11) incorporating a movable electrode (5.2) at least on the side of its free end, the actuation of the electrostatic actuating means (5) from a rest position to a working position having the effect of attracting the movable electrode (5.2) towards the fixed electrode (6.2) which is placed facing and displacing the liquid (4) located at the level of the fastening region (200) towards the central zone (2.1) so as to adjust the radius of curvature of the membrane.

2. Optical device according to claim 1, wherein the film (20) comprises at least one continuous slayer (20.1) which extends over its whole surface.

3. Optical device according to one of the preceding claims, wherein the foot (5.12) is fixed to the film (20) or forms an integral 1 part of the film (20).

4. Optical device according to one of the preceding claims, wherein the leg (5.11) is divided on the side of its free end.

5. Optical device according to one of the preceding claims, wherein the foot (5.12) has ramifications, a leg (5.11) stemming from each ramification.

6. Optical device according to one of the preceding claims, wherein a foot (5.12) cooperates with several legs (5.11).

7. Optical device according to one of the preceding claims, wherein the movable parts (5.1) share a single foot (5.12).

8. Optical device according to one of the preceding claims, wherein the leg (5.11) is merged with the movable electrode (5.2).

9. Optical device according to one or claims 1 to 7, wherein the movable electrode (5.2) is one of the constituent of the leg (5.11).

10. Optical device according to one of the preceding claims, wherein the membrane (2) further comprises a conductive path (5.20) connected to the movable electrode (5.2) which runs on the film (20).

11. Optical device according to claim 10, wherein the conductive path (5.20) is divided on the film (20) into two strands (5.20a, 5.20b) substantially asymmetrical in relation to the leg (5.11).

12. Optical device according to one of claims 3 to 11, wherein the film (20) comprises at the level of the intermediate zone (2.2) a reinforced region (2.21) at the level of which the foot (5.12) is fastened to the film. (20).

13. Optical device according to one or the preceding claims, wherein the film (20) comprises a zone with increased flexibility (2.4) between the anchoring zone (2.3) and the intermediate zone (2.2).

14. Optical device according to one of the preceding claims, wherein the film (20) comprises a reinforcement zone (2.5) between the central zone (2.1) and the intermediate zone (2.2).

15. Optical device according to one of the preceding claims, wherein the leg (5.11) comprises several segments (50, 51) placed end to end, extending in different directions.

16. Optical device according to one of the preceding claims, wherein the free end (5.13) extends beyond the edge of the film (20).

17. Optical device according to one of the preceding claims, wherein the fixed electrode (6.2) cooperates with one or more movable electrodes (5.2).

18. Optical device according to one of the preceding claims, further comprising at least one fixed sacrificed leg (511), the end (5.13) of which is fastened to the support (1), this fixed sacrifice leg (511) being intended to be connected to an energy source (U) and to supply via the foot (5.12) to which it is connected at least one movable electrode (5.2) of a movable part (5.1).

## Patentansprüche

1. Optische Vorrichtung, umfassend eine auf reversible Weise verformbare Membran (2), welche einen flexiblen Film (20) umfasst, mit wenigstens einem Umfangs-Verankerungsbereich (2.3), einem mittleren Bereich (2.1) und einem Zwischenbereich (2.2) zwischen dem mittleren Bereich (2.1) und dem Umfangs-Verankerungsbereich (2.3), wobei die Membran auf der Höhe ihres Verankerungsbereichs (2.3) an einem Träger (1) verankert ist, und elektrostatische Betätigungsmittel (5) mit einer oder mehreren festen, von dem Träger gehaltenen Elektroden (6.2) und mit einem oder mehreren beweglichen Teilen (5.1), **dadurch gekennzeichnet, dass** der Träger und die Membran dazu beitragen, ein konstantes Flüssigkeitsvolumen (4) in Kontakt mit einer der Flächen des Films (20) einzuschließen, wobei die beweglichen Teile der Betätigungsmittel jeweils aus einem Bein (5.11) gebildet sind, welches auf einer Seite in einem Fuß (5.12) endet, der mechanisch mit einem Verbindungsbereich (200) des Films fest verbunden ist, welcher sich in dem Zwischenbereich (2.2) befindet, und auf der anderen Seite in einem freien Ende (5.13), welches mechanisch nicht fest mit einem Verbindungsbereich des Films (20) verbunden ist, wobei das Bein (5.11) wenigstens auf der Seite steines freien Endes eine bewegliche Elektrode (5.2) umfasst, wobei die Betätigung der elektrostatischen Betätigungsmittel (5) aus einer Ruheposition in eine Arbeitsposition bewirkt, dass die bewegliche Elektrode (5.2) zu der festen Elektrode (6.2) hin angezogen wird, welche gegenüber positioniert ist, und dass die Flüssigkeit (4), die sich auf Höhe des Verbindungsbereiches (200) befindet, zu dem mittleren Bereich (2.1) auf eine solche Weise verlagert wird, dass der Krummungsradius der Membran eingestellt wird.

2. Optische Vorrichtung nach Anspruch 1, wobei der Film (20) wenigstens eine durchgehende Schicht (20.1) umfasst, welche sich über seine ganze Oberfläche erstreckt.

3. Optische Vorrichtung nach einem der vorhergehenden Ansprüche, wobei der Fuß (5.12) an dem Film (20) befestigt ist oder einen integralen Bestandteil des Films (20) bildet.

4. Optische Vorrichtung nach einem der vorhergehenden Ansprüche, wobei das Bein (5.11) auf der Seite seines freien Endes verzweigt ist.

5. Optische Vorrichtung nach einem der vorhergehenden Ansprüche, wobei der Fuß (5.12) Verzweigungen aufweist, wobei ein Bein (5.11) von jeder Verzweigung ausgeht.

6. Optische Vorrichtung nach einem der vorhergehenden Ansprüche, wobei ein Fuß (5.12) mit mehreren Beinen (5.11) zusammenwirkt.

7. Optische Vorrichtung nach einem der vorhergehenden Ansprüche, wobei die beweglichen Teile (5.1) sich einen einzelnen Fuß (5.12) teilen.

8. Optische Vorrichtung nach einem der vorhergehenden Ansprüche, wobei das Bein (5.11) mit der beweglichen Elektrode (5.2) vereinigt ist.

9. Optische Vorrichtung nach einem der Ansprüche 1 bis 7, wobei die bewegliche Elektrode (5.2) einer der Bestandteile des Beins (5.11) ist.

10. Optische Vorrichtung nach einem der vorhergehenden Ansprüche, wobei die Membran (2) weiterhin einen mit der beweglichen Elektrode (5.2) verbundenen leitfähigen Pfad (5.20) aufweist, der über den Film (20) läuft.

11. Optische Vorrichtung nach Anspruch 10, wobei der leitfähige Pfad (5.20) sich auf dem Film (20) in zwei Stränge (5.20a, 5.20b) aufteilt, die im Wesentlichen symmetrisch in Bezug auf das Bein (5.11) sind.

12. Optische Vorrichtung nach einem der Ansprüche 3 bis 11, wobei der Film (20) auf der Höhe des Zwischenbereichs (2.2) eine verstärkte Region (2.21) umfasst, auf der Höhe von welcher der Fuß (5.12) mit dem Film (20) verbunden ist.

13. Optische Vorrichtung nach einem der vorhergehenden Ansprüche, wobei der Film (20) einen Bereich mit erhöhter Flexibilität (2.4) zwischen dem Verankerungsbereich (2.3) und dem Zwischenbereich (2.2) aufweist.

14. Optische Vorrichtung nach einem der vorhergehenden Ansprüche, wobei der Film (20) einen Verstärkungsbereich (2.5) zwischen dem mittleren Bereich (2.1) und dem Zwischenbereich (2.2) umfasst.

15. Optische Vorrichtung nach einem der vorhergehenden Ansprüche, wobei das Bein (5.11) mehrere aneinandergefügte Teilstücke (50, 51) umfasst, die sich in unterschiedliche Richtungen erstrecken.

16. Optische Vorrichtung nach einem der vorhergehenden Ansprüche, wobei das freie Ende (5.13) über den Rand des Films (20) hinausgeht.

17. Optische Vorrichtung nach einem der vorhergehenden Ansprüche, wobei die feste Elektrode (6.2) mit einer oder mehreren beweglichen Elektroden (5.2) zusammenwirkt.

18. Optische Vorrichtung nach einem der vorhergehenden Ansprüche, weiter umfassend wenigstens ein festes geopfertes Bein (511), dessen Ende (5.13) mit dem Träger (1) fest verbunden ist, wobei dieses feste geopferte Bein (511) dazu bestimmt ist, mit einer Energiequelle (U) verbunden zu werden, und wenigstens eine bewegliche Elektrode (5.2) eines beweglichen Teils (5.1) durch den Fluß (5.12) zu versorgen, mit welchem es verbunden ist.
